# EUROPEAN PATENT APPLICATION

(11) **EP 2 159 243 A1**
(43) Date of publication of application: **03.03.2010**
(21) Application number: 08764541.2
(22) Date of filing: 22.05.2008
(51) Int. Cl.: C08G 61/00, C09K 11/06, H01L 29/786, H01L 51/05, H01L 51/30, H01L 51/42, H01L 51/50

(54) **POLYMER COMPOUND AND METHOD FOR PRODUCING THE SAME, AND LIGHT-EMITTING MATERIAL, LIQUID COMPOSITION, THIN FILM, POLYMER LIGHT-EMITTING DEVICE, SURFACE LIGHT SOURCE, DISPLAY DEVICE, ORGANIC TRANSISTOR AND SOLAR CELL, EACH USING THE POLYMER COMPOUND**

(30) Priority: 23.05.2007 JP 2007137021
(71) Applicant: Sumitomo Chemical Company, Limited, Tokyo 104-8260 (JP)
(72) Inventor: NOGUCHI, Takanobu, Tsukuba-shi Ibaraki 305-0065 (JP)
(74) Representative: Duckworth, Timothy John
(86) International application number: PCT/JP2008/059480
(87) International publication number: WO 2008/146716

(57) **Abstract**

A polymer compound comprising a repeating unit represented by the following general formula (1):
[General Formula (1)] 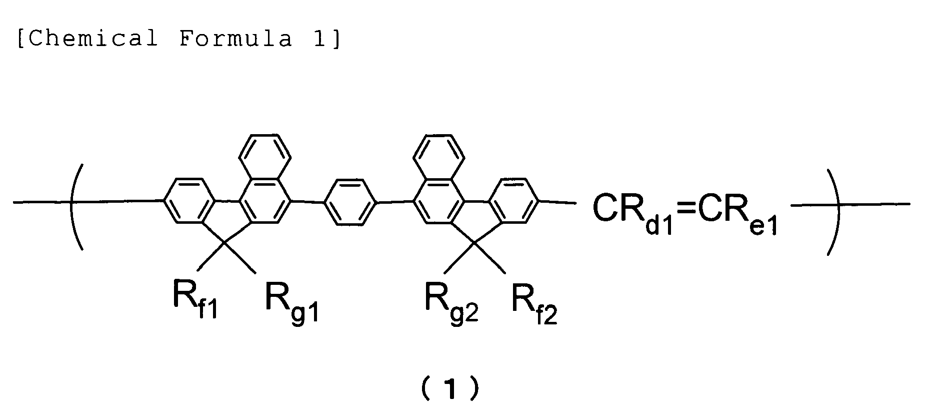 (in the formula, R_{f1}, R_{g1}, R_{f2}, and R_{g2} are the same or different, and each represents any one of an alkyl group having 1 to 12 carbon atoms, a phenyl group, a phenyl group substituted by an alkyl group having 1 to 12 carbon atoms, and a phenyl group substituted by an alkoxy group having 1 to 12 carbon atoms, and R_{d1} and Rₑ₁ are the same or different, and each represents any one of a hydrogen atom, an alkyl group having 1 to 12 carbon atoms, and a phenyl group).

## Description

### Technical Field

The present invention relates to: a polymer compound; a method for producing the same; and a light-emitting material, a liquid composition, a thin film, a polymer light-emitting device, a surface light source, a display device, an organic transistor and a solar cell, each using the polymer compound.

### Background of the Invention

Solvent-soluble polymer compounds are useful as materials for producing, for example, light-emitting devices and the like, because the solvent-soluble polymer compounds can be formed into organic layers in light-emitting devices and the like by application methods. In this connection, various kinds of polymer compounds have been studied, and various poly(arylene vinylene)-based polymer compounds, which are examples of the polymer compound, have been disclosed, as of now.

As examples of such poly(arylene vinylene)-based polymer compounds, Synthetic Metals (vol. 119), published in 2001, pp. 149 to 150 (Document 1) discloses polymer compounds each having a specific triphenylamine skeleton. Meanwhile, Japanese Unexamined Patent Application Publication No. Sho 61-103923 (Document 2) discloses poly(arylene vinylene)-based polymer compounds each having a phenothiazine skeleton in the main chain. Moreover, Synthetic Metals (vol. 74), published in 1995, pp. 71 to 74 (Document 3) discloses poly(arylene vinylene)-based polymer compounds each having a thiophene ring skeleton.

### Disclosure of the Invention

However, conventional poly(arylene vinylene)-based polymer compounds as described in the above-described Documents 1 to 3 are not necessarily sufficient in terms of fluorescence intensity.

The present invention has been made in view of the above-described problem of the conventional techniques, and an object of the present invention is to provide: a polymer compound exhibiting a sufficiently high fluorescence intensity and being suitably usable as a light-emitting material, a charge transport material, and the like; a method for producing the same; and a light-emitting material, a liquid composition, a thin film, a polymer light-emitting device, a surface light source, a display device, an organic transistor and a solar cell, each using the polymer compound.

The present inventors have made earnest study to achieve the above-described object. As a result, the present inventors have found that inclusion of a repeating unit represented by the following general formula (1) makes it possible to obtain a polymer compound exhibiting a sufficiently high fluorescence intensity and being suitably usable as a light-emitting material and a charge transport material, and further a material for organic transistors, solar cells, and the like. This finding has led the present inventors to complete the present invention.

Specifically, a polymer compound of the present invention comprises a repeating unit represented by the following general formula (1).
[General Formula (1)]

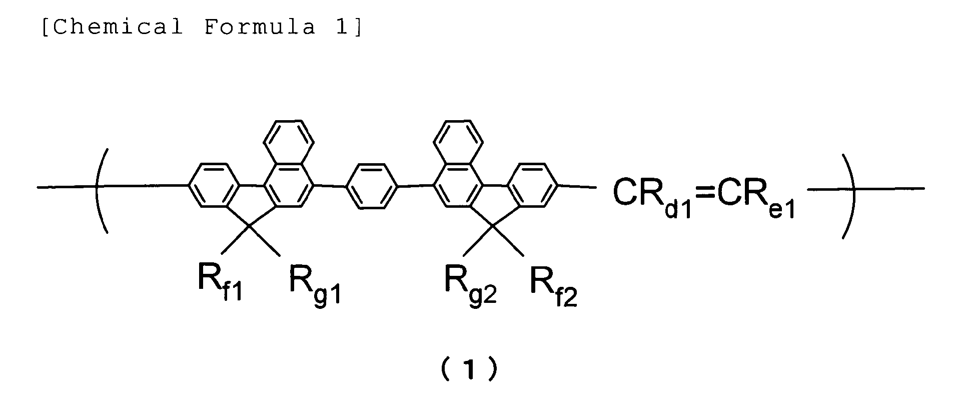

(In the formula, R_{f1}, R_{g1}, R_{f2}, and R_{g2} are the same or different, and each represents any one of an alkyl group having 1 to 12 carbon atoms, a phenyl group, a phenyl group substituted by an alkyl group having 1 to 12 carbon atoms, and a phenyl group substituted by an alkoxy group having 1 to 12 carbon atoms, and R_{d1} and Rₑ₁ are the same or different, and each represents any one of a hydrogen atom, an alkyl group having 1 to 12 carbon atoms, and a phenyl group).

The above-described polymer compound of the present invention may comprise a repeating unit other than the repeating unit represented by the general formula (1). Preferable example of the repeating unit which can be included in the above-described polymer compound of the present invention, and which is other than one represented by the general formula (1) is a repeating unit represented by the following general formula (2).

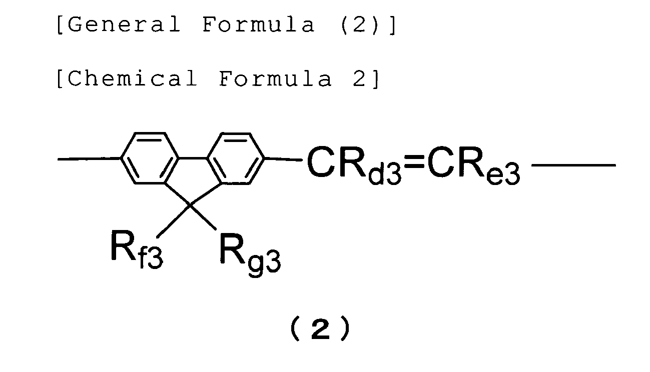

(In the formula, R_{f3} and R_{g3} are the same or different, and each represents any one of an alkyl group having 1 to 12 carbon atoms, a phenyl group, a phenyl group substituted by an alkyl group having 1 to 12 carbon atoms, and a phenyl group substituted by an alkoxy group having 1 to 12 carbon atoms, and R_{d3} and Rₑ₃ are the same or different, and each represents any one of a hydrogen atom, an alkyl group having 1 to 12 carbon atoms and a phenyl group.)

Meanwhile, in the above-described polymer compound of the present invention, at least one of R_{d1} and Rₑ₁ in the general formula (1) is preferably an alkyl group having 1 to 12 carbon atoms. Moreover, at least one of R_{d3} and Rₑ₃ in the general formula (2) is preferably an alkyl group having 1 to 12 carbon atoms.

Furthermore, in the above-described polymer compound of the present invention, at least one of R_{d1} and Rₑ₁ in the general formula (1) is preferably a phenyl group. Moreover, at least one of R_{d3} and Rₑ₃ in the general formula (2) is preferably a phenyl group.

A method for producing a polymer compound of the present invention is a method for producing the above-described polymer compound of the present invention, the method comprising reacting a compound represented by the following general formula (100) with a compound represented by the following general formula (200) in the presence of a palladium catalyst and a base to obtain the polymer compound.

[General Formula (100)] X¹-C(A¹)=C(A²)-X² (100)

(In the formula, A¹ and A² are the same or different, and each represents any one of a hydrogen atom, an alkyl group having 1 to 12 carbon atoms and a phenyl group, and X¹ and X² are the same or different, and each represents any one of a boronic acid group and a boronic ester group.)

[General Formula (200)] Y¹-Ar₂₀₀-Y² (200)

{In the formula, Ar₂₀₀ represents a group represented by the following formula (201): 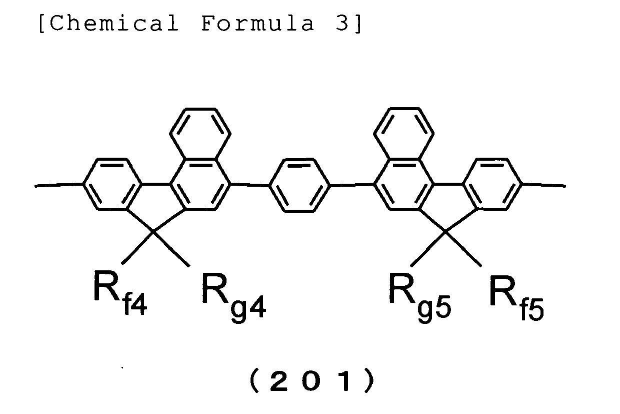 (in the formula, R_{f4}, R_{g4}, R_{f5}, and R_{g5} are the same or different, and each represents any one of an alkyl group having 1 to 12 carbon atoms, a phenyl group, a phenyl group substituted by an alkyl group having 1 to 12 carbon atoms, and a phenyl group substituted by an alkoxy group having 1 to 12 carbon atoms), and Y¹ and Y² are the same or different, and each represents any one of a halogen atom, an alkyl sulfonate group, an aryl sulfonate group and an aryl alkyl sulfonate group}.

A liquid composition of the present invention comprises: the above-described polymer compound of the present invention; and a solvent. A light-emitting material, a thin film, an organic transistor and a solar cell of the present invention each comprise the above-described polymer compound of the present invention.

Meanwhile, a polymer light-emitting device of the present invention comprises an organic layer containing the above-described polymer compound of the present invention, said organic layer being located between electrodes including an anode and a cathode.

Meanwhile, a surface light source and a display device of the present invention each comprise the above-described polymer light-emitting device of the present invention.

According to the present invention, it is possible to provide: a polymer compound exhibiting a sufficiently high fluorescence intensity, and being suitably usable as a light-emitting material, a charge transport material, and the like; a method for producing the same; and a light-emitting material, a liquid composition, a thin film, a polymer light-emitting device, a surface light source, a display device, an organic transistor and a solar cell, each using the polymer compound.

### Detailed Description of the Preferred Embodiments

Hereinafter, the present invention will be described in detail on the basis of preferred embodiments thereof.

### [Polymer Compound]

A polymer compound of the present invention comprises a repeating unit represented by the following general formula (1).
[General Formula (1)] 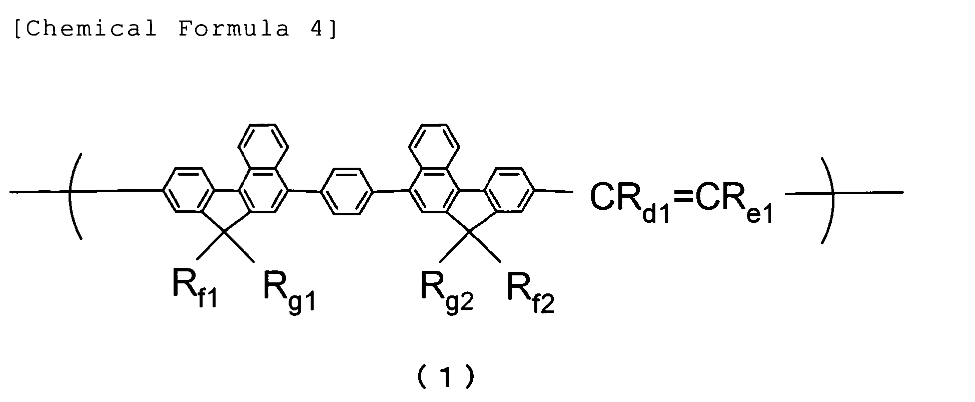 (In the formula, R_{f1}, R_{g1}, R_{f2}, and R_{g2} are the same or different, and each represents any one of an alkyl group having 1 to 12 carbon atoms, a phenyl group, a phenyl group substituted by an alkyl group having 1 to 12 carbon atoms, and a phenyl group substituted by an alkoxy group having 1 to 12 carbon atoms, and R_{d1} and Rₑ₁ are the same or different, and each represents any one of a hydrogen atom, an alkyl group having 1 to 12 carbon atoms and a phenyl group.)

The alkyl group which may be selected as R_{f1}, R_{g1}, R_{f2}, and R_{g2} in the general formula (1) is an alkyl group having 1 to 12 carbon atoms. Such an alkyl group may be linear, branched or cyclic, and moreover may have substituents. Examples of such an alkyl group having 1 to 12 carbon atoms include a methyl group, an ethyl group, a propyl group, an i-propyl group, a butyl group, an i-butyl group, a s-butyl group, a t-butyl group, a pentyl group, a hexyl group, a cyclohexyl group, a heptyl group, an octyl group, a 2-ethylhexyl group, a nonyl group, a decyl group, a 3,7-dimethyloctyl group, a lauryl group, a trifluoromethyl group, a pentafluoroethyl group, a perfluorobutyl group, a perfluorohexyl group, a perfluorooctyl group, and the like. Among such alkyl groups each having 1 to 12 carbon atoms, a butyl group, an i-butyl group, a t-butyl group, a pentyl group, a hexyl group, a heptyl group, an octyl group, a 2-ethylhexyl group, a nonyl group, a decyl group, and a 3, 7-dimethyloctyl group are preferable, and a hexyl group, a heptyl group, an octyl group, a 2-ethylhexyl group, and a 3,7-dimethyloctyl group are more preferable, from the viewpoint of solubility of the polymer compound in a solvent.

The phenyl group substituted by an alkyl group having 1 to 12 carbon atoms, which may be selected as R_{f1}, R_{g1}, R_{f2}, and R_{g2} in the general formula (1), may be any one of phenyl groups, as long as the phenyl groups are those in each of which the above-described alkyl group having 1 to 12 carbon atoms is introduced into a phenyl ring as a substituent. The number of the above-described substituents on the phenyl ring is preferably 1 to 5, (more preferably 1 to 3, particularly preferably 1). Examples of such an alkyl group as the substituent on the phenyl ring include the same ones as the above-described alkyl groups each of which has 1 to 12 carbon atoms and which may be selected as R_{f1}, R_{g1}, R_{f2}, and R_{g2}. Examples of such a phenyl group substituted by an alkyl group having 1 to 12 carbon atoms include a methyl group-substituted phenyl group, an ethyl group-substituted phenyl group, a propyl group-substituted phenyl group, an i-propyl group-substituted phenyl group, a butyl group-substituted phenyl group, an i-butyl group-substituted phenyl group, a s-butyl group-substituted phenyl group, a t-butyl group-substituted phenyl group, a pentyl group-substituted phenyl group, a hexyl group-substituted phenyl group, a cyclohexyl group-substituted phenyl group, a heptyl group-substituted phenyl group, an octyl group-substituted phenyl group, a 2-ethylhexyl group-substituted phenyl group, a nonyl group-substituted phenyl group, a decyl group-substituted phenyl group, a 3,7-dimethyloctyl group-substituted phenyl group, a lauryl group-substituted phenyl group, a trifluoromethyl group-substituted phenyl group, a pentafluoroethyl group-substituted phenyl group, a perfluorobutyl group-substituted phenyl group, a perfluorohexyl group-substituted phenyl group, a perfluorooctyl group-substituted phenyl group, and the like. Among these, from the view point of solubility of the polymer compound in a solvent, a butyl group-substituted phenyl group, an i-butyl group-substituted phenyl group, a t-butyl group-substituted phenyl group, a hexyl group-substituted phenyl group, a heptyl group-substituted phenyl group, an octyl group-substituted phenyl group, a 2-ethylhexyl group-substituted phenyl group, a nonyl group-substituted phenyl group, a decyl group-substituted phenyl group, and a 3,7-dimethyloctyl group-substituted phenyl group are preferable.

Moreover, the phenyl group substituted by an alkoxy group having 1 to 12 carbon atoms, which may be selected as R_{f1}, R_{g1}, R_{f2}, and R_{g2} in the general formula (1), may be any one of phenyl groups, as long as the phenyl groups are those in each of which an alkoxy group having 1 to 12 carbon atoms is introduced into a phenyl ring as a substituent. The number of the substituent on the phenyl ring is preferably 1 to 5 (more preferably 1 to 3, and particularly preferably 1). Such an alkoxy group as the substituent has 1 to 12 carbon atoms, and examples thereof include methoxy, ethoxy, propyloxy, isopropyloxy, butoxy, isobutoxy, s-butoxy, t-butoxy, pentyloxy, hexyloxy, cyclohexyloxy, heptyloxy, octyloxy, 2-ethylhexyloxy, nonyloxy, decyloxy, 3,7-dimethyloctyloxy, lauryloxy, and the like. Such alkoxy groups may further include substituents.

Examples of such a phenyl group substituted by an alkoxy group having 1 to 12 carbon atoms include a methoxy group-substituted phenyl group, an ethoxy group-substituted phenyl group, a propyloxy group-substituted phenyl group, an i-propyloxy group-substituted phenyl group, a butoxy group-substituted phenyl group, an i-butoxy group-substituted phenyl group, a s-butoxy group-substituted phenyl group, a t-butoxy group-substituted phenyl group, a pentyloxy group-substituted phenyl group, a hexyloxy group-substituted phenyl group, a cyclohexyloxy group-substituted phenyl group, a heptyloxy group-substituted phenyl group, an octyloxy group-substituted phenyl group, a 2-ethylhexyloxy group-substituted phenyl group, a nonyloxy group-substituted phenyl group, a decyloxy group-substituted phenyl group, a 3,7-dimethyloctyloxy group-substituted phenyl group, a lauryloxy group-substituted phenyl group, a trifluoromethoxy group-substituted phenyl group, a pentafluoroethoxy group-substituted phenyl group, a perfluorobutoxy group-substituted phenyl group, a perfluorohexyloxy group-substituted phenyl group, a perfluorooctyloxy group-substituted phenyl group, a methoxymethyloxy group-substituted phenyl group, a 2-methoxyethyloxy group-substituted phenyl group, and the like. Among such phenyl groups each substituted by an alkoxy group having 1 to 12 carbon atoms, from the view point of solubility of the polymer compound in a solvent, a butoxy group-substituted phenyl group, an i-butoxy group-substituted phenyl group, a t-butoxy group-substituted phenyl group, a pentyloxy group-substituted phenyl group, a hexyloxy group-substituted phenyl group, a heptyloxy group-substituted phenyl group, an octyloxy group-substituted phenyl group, a 2-ethylhexyloxy group-substituted phenyl group, a nonyloxy group-substituted phenyl group, a decyloxy group-substituted phenyl group, a 3,7-dimethyloctyloxy group-substituted phenyl group, and a lauryloxy group-substituted phenyl group are preferable.

Note that, from the viewpoint of the easiness of the synthesis of a monomer, it is preferable that R_{f1} and R_{g1} are the same group and that R_{f2} and R_{g2} are the same group, and further, it is more preferable that R_{f1}, R_{g1}, R_{f2}, and R_{g2} are the same group.

Meanwhile, R_{d1} and Rₑ₁ in the general formula (1) are the same or different, and each represents any one of a hydrogen atom, an alkyl group having 1 to 12 carbon atoms, and a phenyl group. The alkyl group which may be selected as such R_{d1} and Rₑ₁ is an alkyl group having 1 to 12 carbon atoms. Such an alkyl group may be linear, branched or cyclic, and further may have a substituent. Examples of such an alkyl group having 1 to 12 carbon atoms include a methyl group, an ethyl group, a propyl group, an i-propyl group, a butyl group, an i-butyl group, a s-butyl group, a t-butyl group, a pentyl group, a hexyl group, a cyclohexyl group, a heptyl group, an octyl group, a 2-ethylhexyl group, a nonyl group, a decyl group, a 3,7-dimethyloctyl group, a lauryl group, a trifluoromethyl group, a pentafluoroethyl group, a perfluorobutyl group, a perfluorohexyl group, a perfluorooctyl group, and the like. Among such alkyl groups each having 1 to 12 carbon atoms, from the viewpoint of solubility of the polymer compound in a solvent, a propyl group, an i-propyl group, a butyl group, an i-butyl group, a t-butyl group, a pentyl group, a hexyl group, a heptyl group, an octyl group, a 2-ethylhexyl group, a nonyl group, a decyl group, and a 3,7-dimethyloctyl group are preferable, and a propyl group, an i-propyl group, a butyl group, an i-butyl group, a pentyl group, a hexyl group, a heptyl group, an octyl group, and a 2-ethylhexyl group are more preferable.

In the polymer compound of the present invention, from the viewpoint of solubility of the polymer compound in a solvent, at least one of R_{d1} and Rₑ₁ in the general formula (1) is preferably the alkyl group having 1 to 12 carbon atoms. Furthermore, in the polymer compound of the present invention, from the viewpoints of lengthening absorption and emission wavelengths of a thin film formed of the polymer compound and of heat resistance of the thin film, at least one of R_{d1} and Rₑ₁ in the general formula (1) is preferably the phenyl group.

Specific examples of the repeating unit represented by the general formula (1) include repeating units represented by the following general formulae:

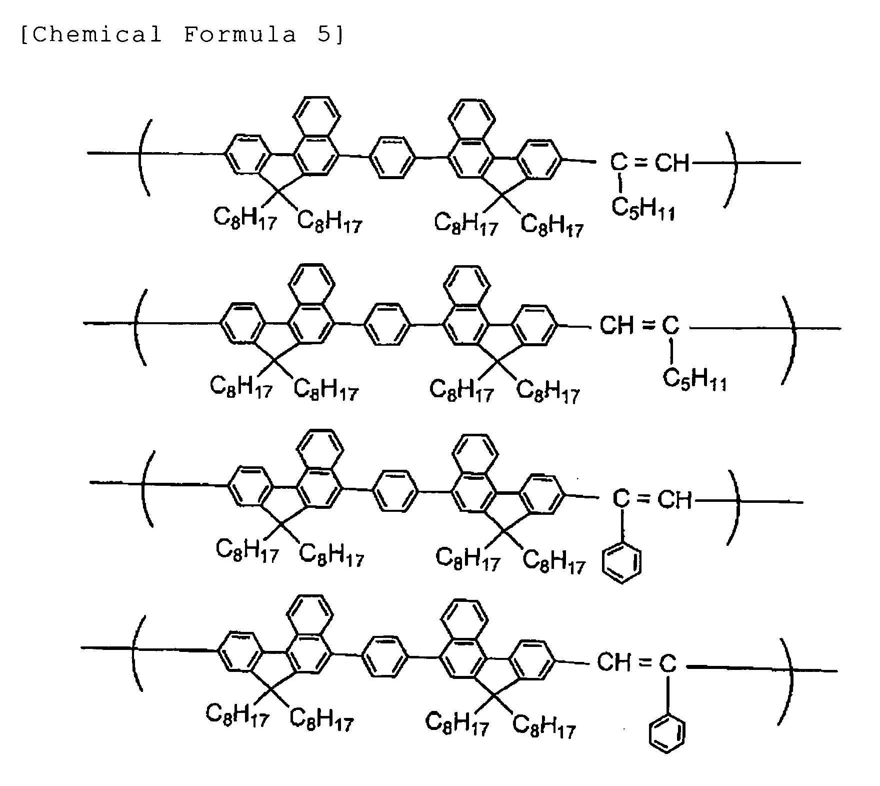

The polymer compound of the present invention needs to comprise at least one kind of the repeating units represented by the formula (1), and may comprise two or more kinds of the repeating units. In the polymer compound of the present invention, the total amount of the repeating units which are included in the polymer compound and which are represented by the general formula (1) is preferably 5% by mole or more, more preferably 10% by mole or more, and further preferably 40% by mole or more, relative to all repeating units. If the ratio of the total amount of the repeating units represented by the general formula (1) is less than the lower limit, the fluorescence intensity and the solubility in a solvent tend to be lowered.

Meanwhile, the polymer compound of the present invention may further comprise a different repeating unit other than the repeating unit represented by the general formula (1), in a range where the fluorescent property and the charge transport property are not impaired. From the viewpoints of the fluorescence intensity and the solubility in a solvent, it is preferable that a repeating unit represented by the following general formula (2): 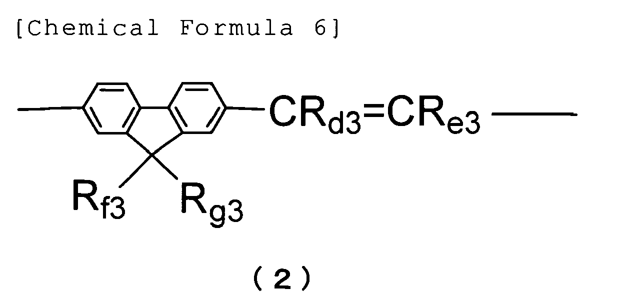 (in the formula, R_{f3} and R_{g3} are the same or different, and each represents any one of an alkyl group having 1 to 12 carbon atoms, a phenyl group, a phenyl group substituted by an alkyl group having 1 to 12 carbon atoms, and a phenyl group substituted by an alkoxy group having 1 to 12 carbon atoms, and R_{d3} and Rₑ₃ are the same or different, and each represents any one of a hydrogen atom, an alkyl group having 1 to 12 carbon atoms and a phenyl group.) is further comprised as such a different repeating unit.

Examples of such an alkyl group having 1 to 12 carbon atoms, the phenyl group substituted by an alkyl group having 1 to 12 carbon atoms, and the phenyl group substituted by an alkoxy group having 1 to 12 carbon atoms, each of the groups being selected as R_{f3} or R_{g3} in the general formula (2), include the same alkyl group having 1 to 12 carbon atoms, the same phenyl group substituted by an alkyl group having 1 to 12 carbon atoms and the same phenyl group substituted by an alkoxy group having 1 to 12 carbon atoms as those described as R_{f1}, R_{g1}, R_{f2}, and R_{g2} in the general formula (1). As such R_{f3} and R_{g3}, it is preferable that R_{f3} and R_{g3} are the same group from the viewpoint of the easiness of the synthesis.

Meanwhile, examples of the alkyl group having 1 to 12 carbon atoms which may be selected as R_{d3} or Rₑ₃ in the general formula (2) include the same alkyl group having 1 to 12 carbon atoms as those described as R_{d1}, and Rₑ₁ in the general formula (1).

In such a repeating unit represented by the general formula (2), at least one of R_{d3} and Rₑ₃ in the general formula (2) is preferably an alkyl group having 1 to 12 carbon atoms from the viewpoints of solubility of the polymer compound and fluorescence intensity thereof, and at least one of R_{d3} and Rₑ₃ in the general formula (2) is preferably a phenyl group from the viewpoints of lengthening absorption and emission wavelengths of a thin film of the polymer compound, and of heat resistance and fluorescence intensity of the thin film.

In a case where the repeating unit represented by the general formula (2) is included, a polymer compound whose a total amount of the repeating units represented by the general formula (1) and (2) is 10% by mole or more relative to all repeating units is preferable, a polymer compound whose the total amount is 20% by mole or more is more preferable, a polymer compound whose the total amount is 50% by mole or more is further preferable, and a polymer compound whose the total amount is 80% by mole or more is particularly preferable, as the polymer compound of the present invention.

Moreover, as a different repeating unit other than the repeating units represented by the general formula (1), the polymer compound of the present invention may comprise, for example, a repeating unit represented by the following general formula (3):

-Ar₃₀₀-Ar₃₀₀- (3)

(in the formula, Ar₃₀₀S are the same or different, and each represents one selected from the group consisting of an arylene group, a divalent heterocyclic group and a divalent aromatic amine residue). Such a repeating unit represented by the general formula (3) is favorable from the viewpoint of improvement in the strength and durability of a thin film of polymer compound.

Examples of such an arylene group which may be selected as each Ar₃₀₀ in the general formula (3) include a phenylene group, a naphthalenediyl group, an anthracenediyl group, a pyrenediyl group, a fluorenediyl group, and the like. Among these, a fluorenediyl group is preferable. Meanwhile, examples of the divalent heterocyclic group which may be selected as each of the above-described Ar₃₀₀ include a thiophenediyl group, a pyrrolediyl group, a furandiyl group, a pyridinediyl group, a benzothiadiazolediyl group, a dibenzofurandiyl group, a dibenzothiophenediyl group, a phenoxazinediyl group, a carbazolediyl group, and the like. Among these, a dibenzofurandiyl group, a dibenzothiophenediyl group, and a phenoxazinediyl group are preferable. Moreover, the divalent aromatic amine residue represented by the above-described Ar₃₀₀ is not particularly limited, as long as the divalent aromatic amine residue is a residue obtainable by removing two hydrogen atoms from aromatic rings of an aromatic amine, and an example thereof is an aromatic amine residue represented by the following
general formula (4):

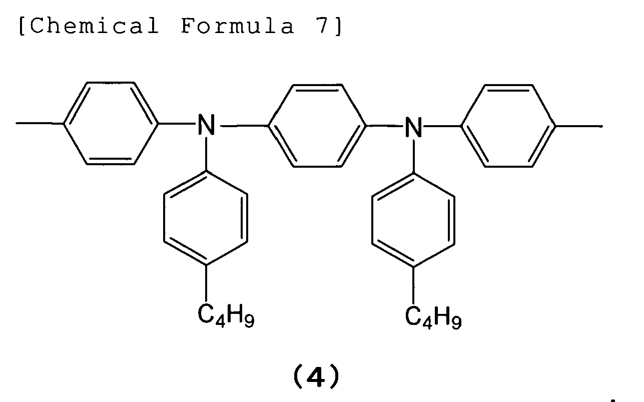

In the repeating unit represented by the general formula (3), at least one of the groups represented by Ar₃₀₀s is preferably any one of an arylene group (more preferably a fluorenediyl group) and a divalent aromatic amine residue (more preferably the group represented by the general formula (4)). Preferred examples of the repeating unit represented by the general formula (3) include a repeating unit in which one of the groups represented by Ar₃₀₀s in the general formula (3) is a fluorenediyl group, and which is represented by the following general formula (3-1): 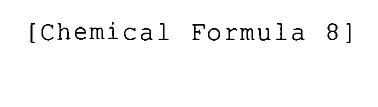 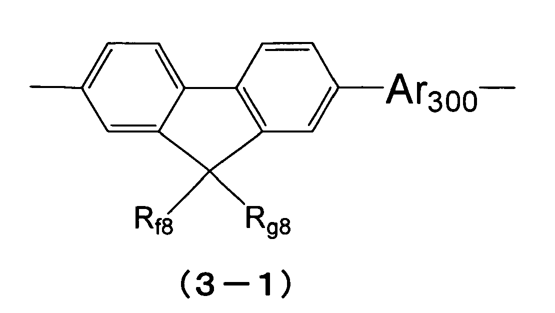 (in the formula, R_{f8} and R_{g8} have the same meaning as R_{f3} and R_{g3} in the general formula (2), and Ar₃₀₀ represents any one of an arylene group, a divalent heterocyclic group, and a divalent aromatic amine residue).
In the repeating unit represented by the general formula (3), it is preferable that one of Ar₃₀₀s be an arylene group (more preferably a fluorenediyl group) and the other one of Ar₃₀₀s be a divalent aromatic amine residue (more preferably a group represented by the general formula (4)).

When the polymer compound of the present invention comprises the repeating unit represented by the general formula (3), the total amount of the repeating units represented by the general formulae (1) and (3) is preferably 10% by mole or more, more preferably 20% by mole or more, further preferably 50% by mole or more, and particularly preferably 80% by mole or more, relative to all repeating units.

From the viewpoints of solubility and film formability, the polymer compound of the present invention preferably has a polystyrene equivalent number average molecular weight of 10³ to 10⁸, and a polystyrene equivalent weight average molecular weight of 2×10³ to 1×10⁷. In the present invention, the "number average molecular weight" and the "weight average molecular weight" are determined, as a polystyrene equivalent number average molecular weight and weight average molecular weight, by gel permeation chromatography (GPC) using tetrahydrofuran as a solvent.

A preferred total number of repeating units included in the polymer compound of the present invention varies depending on kinds of the repeating units and on the content ratio of the repeating units, and can not be generalized. However, from the viewpoint of film formability, the total number of repeating units is preferably 3 to 10000, further preferably 5 to 10000, and particularly preferably 10 to 5000.

The polymer compound of the present invention may be a random, block alternating or graft copolymer; alternatively, the polymer compound of the present invention may be a polymer having an intermediate structure thereamong, for example, a random copolymer having block properties to some extent. As such a polymer compound, a random copolymer having block properties to some extent or a block or graft copolymer is preferable over a completely random copolymer from the viewpoint of obtaining a polymer compound with a higher fluorescence intensity. Note that such a copolymer includes: polymers whose main chain is branched, so that three or more end portions exist therein; and dendrimers.

In the polymer compound of the present invention, the repeating units represented by the general formula (1) may be linked by a non-conjugated unit, or linked by a different repeating unit having such non-conjugated moieties. Examples of such linking structural units serving as linking units include: groups shown in the following general formulae (A); a combination of a group shown in the following general formulae (A) and a vinylene group; a combination of two or more groups shown in the following general formulae (A); and the like.
[General Formulae (A)] 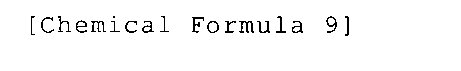 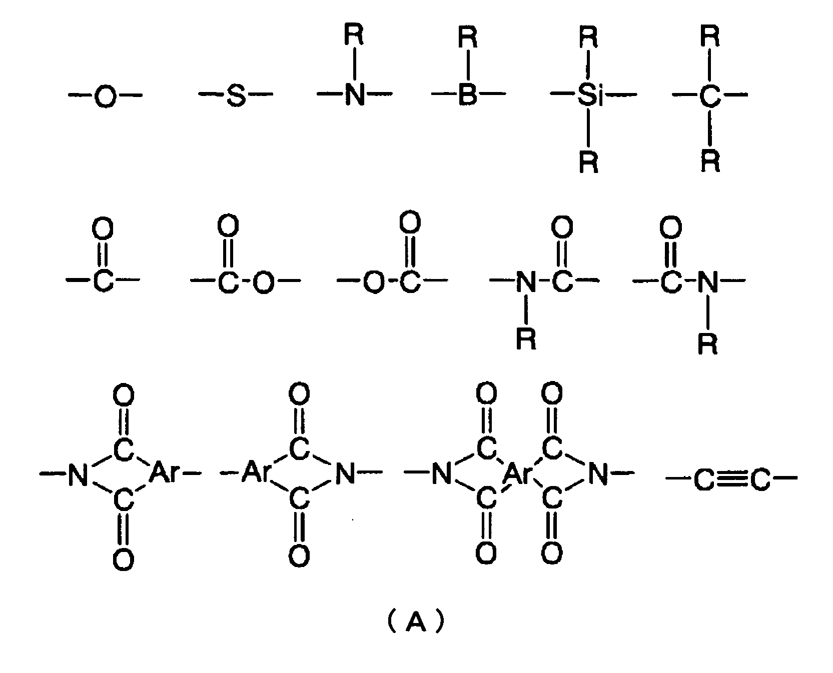 (in the formulae, Rs may be the same or different, and each represents a group selected from the group consisting of a hydrogen atom, an alkyl group having 1 to 20 carbon atoms, an aryl group having 6 to 60 carbon atoms, and a heterocyclic group having 4 to 60 carbon atoms, and Ar represents a hydrocarbon group having 6 to 60 carbon atoms).

If the polymer compound of the present invention has, as its end-group, a group which is polymerization-active and which is intact, emission characteristics and lifetime characteristics may deteriorate in a case where the polymer compound is used as a polymer light-emitting device or the like. Hence, the end-group may be protected by a stable group. When the end-group is protected by a stable group, the polymer compound preferably has a conjugated bond continuous to a conjugated structure of the main chain. An example of such a structure is a structure in which the bond between the end-group and the aryl group or the heterocyclic group is a carbon-carbon bond. Such a stable group for protecting the end-group is not particularly limited, and specific examples thereof includes substituents such as monovalent aromatic compound groups represented by the structural formulae in Chemical Formula 10 in Japanese Unexamined Patent Application Publication No. Hei 9-45478.

The polymer compound of the present invention is useful as, for example, materials used for light-emitting materials, thin films, organic transistors, solar cells, and the like. When the polymer compound of the present invention is used in these applications, the purity of the polymer compound has an effect on the characteristics. Accordingly, monomers before polymerization are preferably purified by a method such as distillation, sublimation purification, or recrystallization, and then polymerized. After the synthesis, it is preferable to perform purification treatment such as reprecipitation purification, fractionation by chromatography, or the like. When light emission from a thin film comprising the polymer compound of the present invention is utilized, those which exhibit fluorescence and/or phosphorescence in their solid state, are suitably used.

When production or the like of an organic layer in a light-emitting device or the like as described above is performed by using the polymer compound of the present invention, the polymer compound of the present invention may be dissolved in a solvent for use. Examples of good solvents used therefore include chloroform, methylene chloride, dichloroethane, tetrahydrofuran, toluene, xylene, mesitylene, tetralin, decalin, n-butyl benzene, and the like. The added amount of the polymer compound dissolved in such a solvent is preferably 0.1% by mass or more relative to the solvent, although the preferable amount varies depending on the structure of the polymer compound and the molecular weight thereof and cannot be generalized.

Moreover, such a polymer compound of the present invention may be utilized as a composition containing at least one material selected from the group consisting of a material capable of light emission and a hole transport material. Such a material capable of light emission is not particularly limited, and can use a known material as appropriate. Among such materials capable of light emission, examples with a low-molecular weight include: naphthalene derivatives; anthracene and derivatives thereof; perylene and derivatives thereof; dyes such as polymethine-based, xanthene-based, coumarin-based dyes, and cyanine-based; metal complexes of 8-hydroxyquinoline and derivatives thereof; aromatic amines; tetraphenylcyclopentadiene and derivatives thereof; tetraphenylbutadiene and derivatives thereof; and the like. Examples of such materials capable of light emission include: materials described in Japanese Unexamined Patent Application Publication No. Sho 57-51781 and Japanese Unexamined Patent Application Publication No. Sho 59-194393; and the like.

The above-described hole transport material is not particularly limited, and can use a known material as appropriate. Examples of such a hole transport material include: polyvinylcarbazole and derivatives thereof; polysilane and derivatives thereof; polysiloxane derivatives having aromatic amines in their side chains or main chains; pyrazoline derivatives; arylamine derivatives; stilbene derivatives; triphenyldiamine derivatives; polyaniline and derivatives thereof; polythiophene and derivatives thereof; polypyrrole and derivatives thereof; poly(p-phenylene vinylene) and derivatives thereof; poly(2,5-thienylene vinylene) and derivatives thereof; and the like.

The content ratio of the at least one material selected from the group consisting of a material capable of light emission and a hole transport material in such a composition is preferably 1% by mass to 80% by mass, and more preferable 5% by mass to 60% by mass. If the content of such a material is less than the lower limit, sufficient light emission properties and hole transport properties tend not to be imparted. Meanwhile, if the content exceeds the upper limit, the charge transport properties of the polymer compound tend not to be exhibited. Note that, in such a composition, the polymer compound of the present invention may be used alone or in combination, and two or more kinds of the polymer compound of the present invention may be included.

Such a composition preferably further comprises a compound having a polystyrene equivalent number average molecular weight of 10³ to 10⁸, in addition to the polymer compound of the present invention. Such a compound having a polystyrene equivalent number average molecular weight of 10³ to 10⁸ is not particularly limited, and examples thereof include: poly(phenylene) and derivatives thereof; poly(fluorene) and derivatives thereof; poly(benzofluorene) and derivatives thereof; poly(dibenzofuran) and derivatives thereof; poly(dibenzothiophene) and derivatives thereof; poly(carbazole ) and derivatives thereof; poly(thiophene) and derivatives thereof; poly(phenylene vinylene) and derivatives thereof; poly(fluorene vinylene) and derivatives thereof; poly(benzofluorene vinylene) and derivatives thereof; poly(dibenzofuran vinylene) and derivatives thereof; and the like. Note that these derivatives are other than the repeating units represented by the general formulae (1) and (2).

Next, description will be given of a method for preparing the polymer compound of the present invention. The method for preparing the polymer compound of the present invention is not particularly limited, as long as the method makes it possible to prepare the polymer compound comprising the repeating units represented by the general formula (1). Examples thereof include the following methods. Note that monomers (raw material compounds) used in polymerization methods to be described below are any monomers, as long as the monomers are compounds from which the polymer compound comprising the repeating units represented by the general formula (1) can be obtained.

Examples of suitable methods for preparing the polymer compound of the present invention include known methods such as a method described in Japanese Unexamined Patent Application Publication No. Hei 5-202355. More specific examples include production methods which adopt: polymerization by Wittig reaction of a raw material compound having aldehyde groups with a raw material compound having phosphonium salt groups; polymerization by Wittig reaction of a raw material compound having an aldehyde group and a phosphonium salt group; polymerization by Heck reaction of a compound having vinyl groups with a raw material compound having halogen groups; polymerization by Heck reaction of a raw material compound having a vinyl group and a halogen group; polymerization of a raw material compound having aldehyde groups with a raw material compound having alkyl phosphonate groups by a Horner-Wadsworth-Emmons method; polymerization of a raw material compound having an aldehyde group and an alkyl phosphonate group by a Horner-Wadsworth-Emmons method; polycondensation of a raw material compound having two or more halogenated methyl groups by a dehydrohalogenation method; polycondensation of a raw material compound having two or more sulfonium salt groups by a sulfonium salt decomposition method; polymerization by Knoevenagel reaction of a raw material compound having aldehyde groups and a raw material compound having acetonitrile groups, or polymerization by Knoevenagel reaction of a compound containing an aldehyde group and an acetonitrile group; polymerization by McMurry reaction of a raw material compound having two or more aldehyde groups; and the like. As other methods, a polymerization method by Suzuki coupling reaction, a polymerization method by Grignard reaction, and a polymerization method (a Yamamoto reaction method) by using a Ni(0) catalyst, of monomers (raw material compounds) may be adopted. Note that these polymerization methods are preferably performed in an inert atmosphere of nitrogen gas, argon gas, or the like.

Among these preferable methods for preparing the polymer compound of the present invention, the methods which adopt the polymerization by Wittig reaction, the polymerization by Heck reaction, the polymerization by the Horner-Wadsworth-Emmons method, the polymerization by Knoevenagel reaction, the polymerization by Suzuki coupling reaction, and the polymerization (the Yamamoto reaction method) by using a Ni(0) catalyst are preferable, because the structure can be easily controlled.

Normally, as an organic solvent used in such methods, an organic solvent which have been subjected to a sufficient deoxygenation treatment is preferably used in order to suppress side reactions, although the preference depends on raw material compounds used and the adopted reaction method. When such an organic solvent is used, it is also preferable to cause the reaction to proceed in an inert atmosphere. The above-described organic solvent is preferably subjected to a dehydration treatment, as similar to the deoxygenation treatment. Note that the dehydration treatment is not necessarily preferable in a case of a reaction, such as Suzuki coupling reaction, in a two phase system including water.

Examples of such an organic solvent include: saturated hydrocarbons such as pentane, hexane, heptane, octane, and cyclohexane; unsaturated hydrocarbons such as benzene, toluene, ethylbenzene, and xylene; saturated halogenated hydrocarbons such as carbon tetrachloride, chloroform, dichloromethane, chlorobutane, bromobutane, chloropentane, bromopentane, chlorohexane, bromohexane, chlorocyclohexane and bromocyclohexane; unsaturated halogenated hydrocarbons such as chlorobenzene, dichlorobenzene, and trichlorobenzene; alcohols such as methanol, ethanol, propanol, isopropanol, butanol, and t-butyl alcohol; carboxylic acids such as formic acid, acetic acid, and propionic acid; ethers such as dimethyl ether, diethyl ether, methyl-t-butyl ether, tetrahydrofuran, tetrahydropyrane, and dioxane; amines such as trimethylamine, triethylamine, N,N,N',N'-tetramethylethylenediamine, and pyridine; amides such as N,N-dimethylformamide, N,N-dimethylacetamide, N,N-diethylacetamide, and N-methylmorpholine oxide; and the like. These organic solvents may be used alone or as a mixture of two or more kinds.

Moreover, in these preferred methods for preparing the polymer compound of the present invention, it is preferable to add, as appropriate, an alkali or an appropriate catalyst, in order to cause the reaction to proceed. These alkali and appropriate catalyst may be selected in accordance with an adopted type of the reaction. As these alkali and catalyst, those sufficiently dissolved in the organic solvent used for the reaction are preferable. A method for mixing these alkali or catalyst is not particularly limited, and examples thereof include: a method in which, while a reaction liquid containing the raw material compounds and an organic solvent in an inert atmosphere of argon, nitrogen, or the like is being stirred, a solution of an alkali and/or a catalyst is slowly added thereto; and a method in which the above-described reaction liquid is slowly added to a solution containing an alkali and/or a catalyst.

When the above-mentioned Wittig reaction, Horner reaction, or the like is adopted as the preferred method for preparing the polymer compound of the present invention, the reaction is preferably performed by using an alkali in an equivalent amount or more (more preferably in a 1 to 3 equivalent amount) to the functional group of the monomer. When the Wittig reaction, the Horner reaction, the Knoevengel reaction, or the like is adopted, the alkali used is not particularly limited, and examples thereof include metal alcoholates such as potassium-t-butoxide, sodium-t-butoxide, sodium ethylate, and lithium methylate, and the like. Examples of an organic solvent which can be preferably used in a case where the Wittig reaction, the Horner reaction, the Knoevengel reaction, or the like is adopted include N,N-dimethylformamide, tetrahydrofuran, dioxane, toluene, and the like. Moreover, the temperature condition for such reactions is preferably about from room temperature to 150°C. There is a tendency that, by employing such a temperature condition, the reaction can be caused to proceed more efficiently. The reaction time for such a reaction can be any length, as long as the polymerization proceeds sufficiently within the reaction time. The reaction time can be set to 5 minutes to 40 hours, for example. Since standing for a long time after the reaction is unnecessary, the reaction time is preferably set to 10 minutes to 24 hours. If the concentration of a reaction solution containing the raw material compounds and an organic solvent is too dilute, the efficiency of the reaction is poor. If the concentration is too thick, control of the reaction is difficult. Hence, the concentration is preferably in a range from approximately 0.01% by mass or more to the maximum concentration at which the raw material compounds can be dissolved, and more preferably in a range of 0.1 to 40% by mass.

When the above-described Heck reaction is adopted, it is preferable to use a palladium catalyst, and to react monomers in the presence of a base such as triethylamine. When such a Heck reaction is adopted, it is preferable that a relatively high boiling point solvent such as N,N-dimethylformamide or N-methylpyrrolidone be used as the organic solvent, that the reaction temperature be set to approximately 80°C to 160°C, and that the reaction time be set to approximately 1 to 100 hours.

Moreover, when the above-described Suzuki coupling reaction is adopted, it is preferable that the reaction be performed, while, for example, palladium[tetrakis(triphenylphosphine)], a palladium acetate, dichloro bis(triphenylphosphine) palladium (II) or the like is used as the catalyst, and while an inorganic base such as potassium carbonate, sodium carbonate, or barium hydroxide, an organic base such as triethylamine, or an inorganic salt such as cesium fluoride is added in an equivalent amount or more, and preferably a 1 to 10 equivalent amount, to a monomer. Preferable examples of an organic solvent used when the Suzuki coupling reaction is adopted include N,N-dimethylformamide, toluene, dimethoxyethane, tetrahydrofuran, and the like. The base may be added in a form of an aqueous solution, and the reaction may be performed in a two phase system. The temperature condition for such a reaction is preferably a temperature of approximately 50°C to 160°C, although the preferable temperature condition varies depending on the type of the solvent used. Note that the temperature may be raised close to the boiling point of the solvent, and the solvent may be refluxed. Although the reaction time for such a reaction is not particularly limited, the reaction time is preferably approximately 0.1 to 200 hours. Note that such a polymerization reaction is preferably performed in an atmosphere of an inert gas such as argon or nitrogen, and in a reaction system where a Pd (0) catalyst is not inactivated.

As a preferable method for preparing the polymer compound of the present invention, a method for producing a polymer compound of the present invention to be described below is particularly preferable from the viewpoints of easiness of synthesizing the polymer compound.

### [Production Method of Polymer Compound]

Next, a method for producing a polymer compound of the present invention will be described. Specifically, the method for producing a polymer compound of the present invention is a method for producing the above-described polymer compound of the present invention, the method comprising reacting a compound represented by the following general formula (100) with a compound represented by the following general formula (200) in the presence of a palladium catalyst and a base to obtain the polymer compound.

[General Formula (100)] X¹-C(A¹)=C(A²)-X² (100)

(In the formula, A¹ and A² are the same or different, and each represents any one of a hydrogen atom, an alkyl group having 1 to 12 carbon atoms and a phenyl group, and X¹ and X² are the same or different, and each represents any one of a boronic acid group and a boronic ester group.)

[General Formula (200)] Y¹-Ar₂₀₀-Y² (200)

{In the formula, Ar₂₀₀ represents a group represented by the following formula (201): 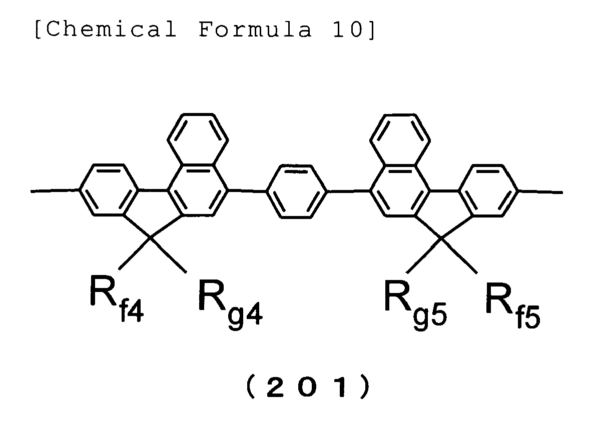 (in the formulae, R_{f4}, R_{g4}, R_{f5}, and R_{g5} are the same or different, and each represents any one of an alkyl group having 1 to 12 carbon atoms, a phenyl group, a phenyl group substituted by an alkyl group having 1 to 12 carbon atoms, and a phenyl group substituted by an alkoxy group having 1 to 12 carbon atoms), and Y¹ and Y² are the same or different, and each represents any one of a halogen atom, an alkyl sulfonate group, an aryl sulfonate group and an aryl alkyl sulfonate group.}

X¹ and X² in the formula (100) are the same or different, and each represents any one of a boronic acid group (the group represented by -B(OH)₂) and a boronic ester group. Examples of such a boronic ester group include groups represented by the following general formulae (101): 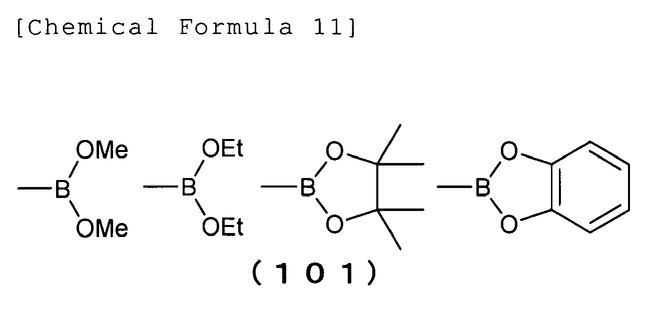 (in the formulae, Me represents a methyl group, and Et represents an ethyl group), and the like.

Examples of alkyl groups each of which has 1 to 12 carbon atoms and which can be selected as A¹ and A² in the general formula (100) include the same one as the alkyl group having 1 to 12 carbon atoms described for R_{d1} and Rₑ₁ in the general formula (1).

Specific examples of the compound represented by the general formula (100) include compounds represented by the following formulae (102): 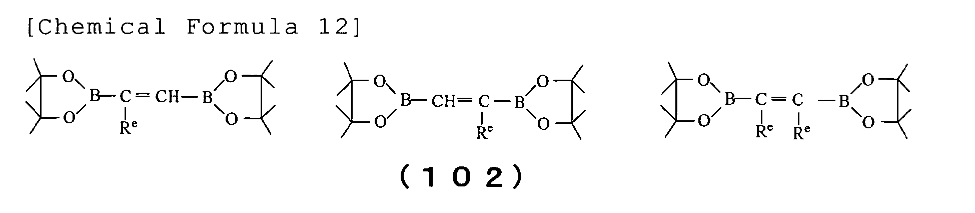 (in the formulae, R^{e}s are the same or different, and each represents any one of an alkyl group having 1 to 12 carbon atoms and a phenyl group), or the like. More specific examples thereof include compounds represented by the following formulae (103): 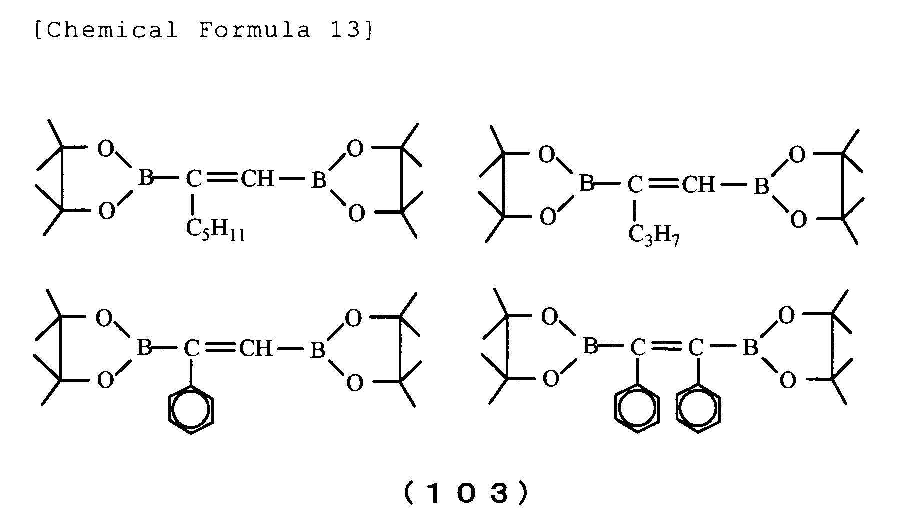 , and the like. Note that examples of the alkyl group having 1 to 12 carbon atoms represented by R^{e} in the formulae (102) are the same ones as those for the alkyl group having 1 to 12 carbon atoms described for R_{d1} and Rₑ₁ in the general formula (1).

Meanwhile, Y¹ and Y² in the general formula (200) are the same or different, and each represents any one of a halogen atom, an alkyl sulfonate group, an aryl sulfonate group and an aryl alkyl sulfonate group. Examples of the halogen atom which may be selected as Y¹ and Y² include a fluorine atom, a chlorine atom, a bromine atom, and an iodine atom. In view of easiness of synthesis of the polymer compound, a bromine atom, and an iodine atom are preferable, and a bromine atom is further preferable. Examples of the alkyl sulfonate group include a methanesulfonate group, an ethanesulfonate group, a trifluoromethanesulfonate group, and the like. Moreover, examples of the aryl sulfonate group include a benzenesulfonate group, a p-toluenesulfonate group, and the like. Examples of the aryl alkyl sulfonate group include a benzylsulfonate group, and the like.

Examples of the alkyl group having 1 to 12 carbon atoms, the phenyl group substituted by an alkyl group having 1 to 12 carbon atoms, and the phenyl group substituted by an alkoxy group having 1 to 12 carbon atoms, each of the groups being selected as any of R_{f4}, R_{g4}, R_{f5}, and R_{g5} in the general formula (201), include the same alkyl group having 1 to 12 carbon atoms, the same phenyl group substituted by an alkyl group having 1 to 12 carbon atoms, and the same phenyl group substituted by an alkoxy group having 1 to 12 carbon atoms as those described as R_{f1}, R_{g1}, R_{f2}, and R_{g2} in the general formula (1). From the viewpoint of the easiness of the synthesis, it is preferable that R_{f4} and R_{g4} are the same group and that R_{f5} and R_{g5} are the same group, and further, it is more preferable that R_{f4}, R_{g4}, R_{f5}, and R_{g5} are the same group.

Moreover, the above-described palladium catalyst is not particularly limited, and any of known palladium catalysts which can be used for reaction of the compounds represented by the general formula (100) and the general formula (200) can be used as appropriate. Examples of the palladium catalyst include palladium [tetrakis(triphenylphosphine)], palladium acetates, dichlorobis(triphenylphosphine) palladium, and the like.

The added amount of the palladium catalyst used when the compounds represented by the general formula (100) and the general formula (200) are reacted is not particularly limited, as long as the added amount is enough to obtain an effect as the catalyst. The added amount is preferably 0.0001 moles to 0.5 moles, and more preferably 0.0003 moles to 0.1 moles, per mole of the compound represented by the general formula (100). If such an added amount of the catalyst is less than the lower limit, the efficiency of the reaction tend to be lowered. Meanwhile, if the added amount exceeds the upper limit, the excessive addition tends to be wasteful and to lower the economy.

Moreover, when one of a palladium acetates is used as the palladium catalyst, for example, a phosphorus compound such as triphenylphosphine, tri(o-tolyl)phosphine, or tri(o-methoxyphenyl)phosphine may be further added for use as a ligand. When such a phosphorus compound is added as a ligand as described above, the added amount of the ligand is preferably 0.5 moles to 100 moles, more preferably 0.9 moles to 20 moles, and further preferably 1 mole to 10 moles, per mole of the palladium catalyst.

The base used when the compounds represented by the general formula (100) and the general formula (200) is not particularly limited, and examples thereof include inorganic bases, organic bases, inorganic salts, and the like. Examples of such inorganic bases include potassium carbonate, sodium carbonate, barium hydroxide, and the like. Examples of the organic bases include triethylamine, tributyl amine, and the like. Moreover, examples of the inorganic salts include caesium fluoride and the like.

The added amount of such a base is preferably 0.5 moles to 100 moles, more preferably 0.9 moles to 30 moles, and further preferably 1 mole to 20 moles, per mole of the compound represented by the formula (100).

When the compounds represented by the general formula (100) and the general formula (200) are reacted, the reaction is preferably performed in an organic solvent. Such an organic solvent is not particularly limited, and examples thereof include N,N-dimethylformamide, toluene, dimethoxyethane, tetrahydrofuran and the like. From the viewpoint of solubility of the poly(arylene vinylene)-based polymer compound to be obtained, toluene, or tetrahydrofuran is preferably used as the organic solvent.

When the compounds represented by the general formula (100) and the general formula (200) are reacted, the reaction may be performed by adding the base to the above-described organic solvent. Furthermore, the base is added in a form of an aqueous solution, and the reaction may be performed in a two phase system. Meanwhile, when an inorganic salt is used as the base, it is preferable that the base be added in a form of an aqueous solution, and the reaction be performed in a two phase system, from the viewpoint of solubility of the inorganic salt.

Moreover, the temperature condition at the time when the compounds represented by the general formula (100) and the general formula (200) are reacted is not generalized, because the temperature condition varies depending on the solvent used and the like. However, the temperature condition is preferably approximately 50°C to 160°C, and, from the viewpoints of obtaining the polymer compound with a higher molecular weight, the temperature condition is more preferably 60°C to 120°C. In such a reaction, the temperature may be raised close to the boiling point of the solvent used, and the solvent may be refluxed.

The condition of time (reaction time) during which the reaction is performed is not particularly limited, and the time at which a desired degree of polymerization is reached may be set as the upper limit of the reaction time. The reaction time is preferably approximately 0.1 hours to 200 hours, and from the viewpoint of reaction efficiency, the reaction time is more preferably approximately 0.5 hours to 30 hours.

The reaction is preferably performed in an inert atmosphere. Such an inert atmosphere is not particularly limited, and may be a system sufficiently deaerated by an inert gas such as argon gas or nitrogen gas.

A preferred example of a method for reacting the compounds represented by the general formula (100) and the general formula (200) is as follows. Specifically, first, air in a polymerization reaction vessel (reaction system) is sufficiently replaced with nitrogen gas, and thereby the polymerization reaction vessel is deaerated. The compound represented by the general formula (100), the compound represented by the general formula (200), and dichloro bis(triphenylphosphine) palladium(II) and, if necessary, a phase-transfer catalyst, for example, quaternary ammonium salt are fed into the polymerization vessel. Further, air in the polymerization vessel is sufficiently replaced with nitrogen gas, and thereby the polymerization vessel is deaerated. Next, the organic solvent (for example, toluene or the like) which is deaerated by bubbling with nitrogen gas in advance is added to the polymerization vessel, to thereby obtain a solution. Next, to the obtained solution, an aqueous solution of a base (for example, a sodium carbonate aqueous solution, or the like) which is deaerated by bubbling with nitrogen gas in advance is added dropwise. Then, the temperature is raised to the reaction temperature by heating, and the temperature is kept for the reaction time (for example, kept for 8 hours at the reflux temperature). Thus, while the inert atmosphere is being maintained, the compounds represented by the general formula (100) and the general formula (200) are reacted by polymerization. Note that, when the obtained polymer compound is caused to comprise a different repeating unit and the like, a different raw material compound is introduced with the compounds represented by the general formula (100) and the general formula (200).

In the method for producing the polymer compound of the present invention, when the repeating unit represented by the general formula (2) is included with the repeating units represented by the general formula (1), it is preferable to use a compound represented by the following general formula (300): 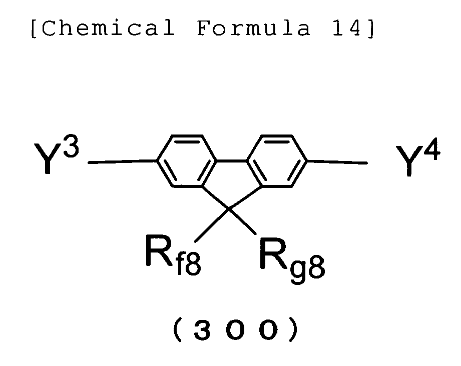 (in the formula, R_{f8} and R_{g8} have the same meaning as R_{f3} and R_{g3} in the general formula (2), and Y³ and Y⁴ have the same meaning as Y¹ and Y² in the general formula (200)), together with the compounds represented by the general formulae (100) and (200). In the method for producing the polymer compound of the present invention, the monomers such as the compounds represented by the general formulae (100), (200) and (300) may be mixed at once, and then reacted; alternatively, the monomers are mixed and reacted in a divided manner, if necessary.

In the method for producing the polymer compound of the present invention, the polymer compound may be produced by a way that, after the compound represented by the general formula (100) and the compound represented by the general formula (200) are reacted, a compound represented by the following formula (301):

X¹-Ar₂₀₀-X² (301)

(in the formula, Ar₃₀₀ has the same meaning as Ar₃₀₀ in the general formula (3), and X¹ and X² have the same meaning as X¹ and X² in the general formula (100)) , and a compound represented by the following general formula (302):

Y¹-Ar₃₀₀-Y² (302)

(in the formula, Ar₃₀₀ has the same meaning as Ar₃₀₀ in the general formula (3), and Y¹ and Y² have the same meaning as Y¹ and Y² in the general formula (200)) are further added and then reaction is performed. Alternatively, the polymer compound may be produced by a way that, after the compound represented by the general formula (301) and the compound represented by the general formula (302) are reacted, the compound represented by the formula (100) and the compound represented by the formula (200) are further added, and then reaction is performed. Note that, these operations may perform repeatedly each.

As the compound represented by the general formula (301), a compound represented by the following general formula (303): 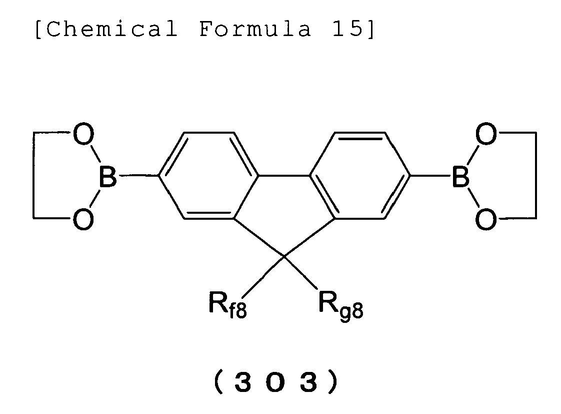 (in the formula, R_{f8} and R_{g8} have the same meaning as R_{f3} and R_{g3} in the general formula (2),) is preferable. Meanwhile, as the compound represented by the general formula (302), the compound represented by the following formula (304): 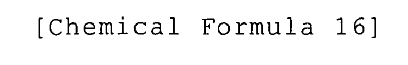 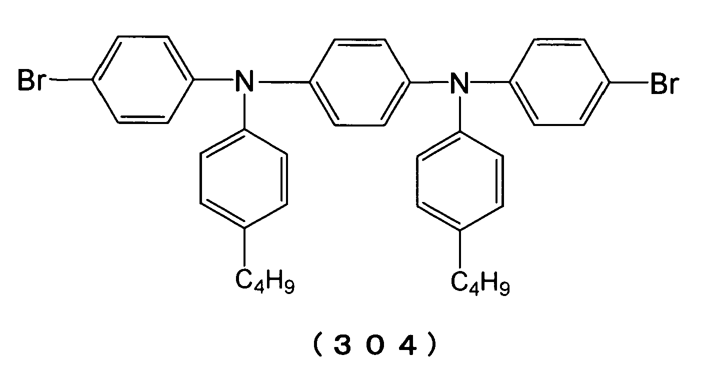 is preferable. The use of such compounds represented by the general formulae (303) and (304) makes it possible to obtain a polymer compound comprising, together with the repeating units represented by the general formula (1), a repeating unit which is represented by the general formula (3-1) where Ar₃₀₀ is a group represented by the general formula (4).

### [Light-Emitting Material]

Next, a light-emitting material of the present invention will be described. The light-emitting material of the present invention comprises the above-described polymer compound of the present invention.

Such a light-emitting material is not particularly limited, as long as the light-emitting material comprises the polymer compound of the present invention. The light-emitting material may comprise a known material capable of light emission, as appropriate. Examples of such a material capable of light emission include: naphthalene derivatives; anthracene and derivatives thereof; perylene and derivatives thereof; dyes such as polymethine-based, xanthene-based, coumarin-based, cyanine-based dyes; metal complexes of 8-hydroxyquinoline and of derivatives thereof; aromatic amine; tetraphenylcyclopentadiene and derivatives thereof; tetraphenylbutadiene and derivatives thereof; and the like. Examples of such a light-emitting material include those described in Japanese Unexamined Patent Application Publication No. Sho 57-51781, and Japanese Unexamined Patent Application Publication No. Sho 59-194393, and the like. As the material capable of light emission, a metal complex capable of light emission from a triplet excited state (i.e., a triplet light-emitting complex: for example, complexes from which phosphorescent light emission is observed, and from which fluorescent light is observed in addition to the phosphorescent light emission are included) can be used as appropriate. Examples of the metal complex capable of light emission from a triplet excited state include those which have been conventionally utilized as low-molecular weight EL materials capable of light emission.

### [Liquid Composition]

Next, a liquid composition of the present invention will be described. The liquid composition of the present invention comprises the above-described polymer compound of the present invention and a solvent. Here, the term "liquid composition" represents a substance which is liquid, and typically represents a substance which is liquid under a normal pressure (i.e., 1 atm) at 25°C . In some cases, such a liquid composition is generally referred to as an ink, an ink composition, a solution, or the like. Moreover, such a liquid composition of the present invention is useful for production of light-emitting devices such as polymer light-emitting devices, and organic transistors.

The ratio of the solvent contained in the liquid composition of the present invention is preferably 1% by mass to 99.9% by mass, more preferably 60% by mass to 99.9% by mass, and further preferably 90% by mass to 99.8% by mass, relative to the total mass of the liquid composition. Though a preferable range of a viscosity of such a liquid composition varies depending on a printing method adopted to produce a thin film or the like by using the liquid composition, the viscosity of such a liquid composition is preferably in the range of 0.5 mPa·s to 500 mPa·s at 25°C. When the adopted printing method is a method in which the liquid composition passes through a discharging apparatus, for example, an ink jet printing method, or the like, the viscosity is more preferably in the range of 0.5 mPa·s to 20 mPa·s at 25°C in order to prevent clogging and flight deflection at the time of the discharge.

As this solvent, a solvent capable of dissolving or dispersing the components other than the solvent in the liquid composition is preferable. Examples of such a solvent include; chlorine-containing solvents such as chloroform, methylene chloride, 1,2-dichloroethane, 1,1,2-trichloroethane, chlorobenzene, and o-dichlorobenzene; ether-based solvents such as tetrahydrofuran, and dioxane; aromatic hydrocarbon-based solvents such as toluene, xylene, trimethylbenzene, and mesitylene; aliphatic hydrocarbon-based solvents such as cyclohexane, methylcyclohexane, n-pentane, n-hexane, n-heptane, n-octane, n-nonane, andn-decane; ketone-based solvents such as acetone, methylethyl ketone, and cyclohexanone; ester-based solvents such as ethyl acetate, butyl acetate, methyl benzoate, and ethyl cellosolve acetate; polyols such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, and 1,2-hexanediol and derivatives thereof; alcohol-based solvents such as methanol, ethanol, propanol, isopropanol, and cyclohexanol; sulfoxide-based solvents such as dimethyl sulfoxide; and amide-based solvents such as N-methyl-2-pyrrolidone, and N,N-dimethylformamide. These solvents may be used alone or in combination of multiple kinds. It is preferable to contain, among these solvents, one or more kinds of organic solvents each of which has a structure having at least one benzene ring, a melting point of 0°C or below, and a boiling point of 100°C or higher, from the viewpoints of viscosity, film formability, and the like.

As such kinds of solvents, aromatic hydrocarbon-based solvents, aliphatic hydrocarbon-based solvents, ester-based solvents, ketone-based solvents are preferable, from the viewpoints of solubility, in the organic solvent, of components other than the solvent in the liquid composition, uniformity at the time of film formation, viscosity characteristics, and the like. Toluene, xylene, ethylbenzene, diethylbenzene, trimethylbenzene, mesitylene, n-propylbenzene, i-propylbenzene, n-butylbenzene, i-butylbenzene, s-butylbenzene, anisole, ethoxybenzene, 1-methylnaphthalene, cyclohexane, cyclohexanone, cyclohexylbenzene, bicyclohexyl, cyclohexenylcyclohexanone, n-heptylcyclohexane, n-hexylcyclohexane, methyl benzoate, 2-propylcyclohexanone, 2-heptanone, 3-heptanone, 4-heptanone, 2-octanone, 2-nonanone, 2-decanone, dicyclohexyl ketone are more preferable, and it is particularly preferable to contain at least one kind of xylene, anisole, mesitylene, cyclohexylbenzene, and bicyclohexyl methyl benzoate.

Moreover, as the solvent contained in the liquid composition of the present invention, it is preferable that two or more kinds of solvents are included, from the viewpoint of film formability and also from the viewpoints of device characteristics and the like. Among these, it is more preferable 2 to 3 kinds of solvents are included, and it is further preferable that two kinds of solvents are included.

When two kinds of solvents are contained in the liquid composition of the present invention, one of the kinds of the solvents may be in a solid state at 25°C. When two kinds of solvents are contained, it is preferable that one of the kinds of solvents have a boiling point of 180°C or higher, and the other one of the kinds of solvents have a boiling point less than 180°C, from the viewpoint of film formability. It is more preferable that the one of the kinds of solvents have a boiling point of 200°C or higher, and the other one of the kinds of solvents have a boiling point less than 180°C. Meanwhile, from the viewpoint of viscosity, 0.2% by mass or more of components in the liquid composition except for the solvents is preferably dissolved in the solvents at 60°C, and 0.2% by mass or more of components in the liquid composition except for the solvents is preferably dissolved in one of the two kinds of solvents at 25°C.

Meanwhile, when three kinds of solvents are contained in the liquid composition of the present invention, one or two of the three kinds of solvents may be in a solid state at 25°C. When three kinds of solvents are contained, it is preferable that at least one of the three kinds of solvents be a solvent having a boiling point of 180°C or higher, and at least one of the three kinds of solvents be a solvent having a boiling point of 180°C or below, from the viewpoint of film formability. It is more preferable that at least one of the three kinds of solvents be a solvent having a boiling point which is 200°C or higher but 300°C or below, and at least one of the three kinds of solvent be a solvent having a boiling point of 180°C or below. Meanwhile, from the viewpoint of viscosity, 0.2% by mass or more of components in the liquid composition except for the solvents is preferably dissolved in two of the three kinds of the solvents at 60°C, and 0.2% by mass or more of components in the liquid composition except for the solvents is preferably dissolved in one of the three kinds of the solvents at 25°C.

When two or more kinds of solvents are contained in the liquid composition of the present invention, a solvent having the highest boiling point accounts for preferably 40 to 90% by mass, more preferably 50 to 90% by mass, and further preferably 65 to 85% by mass, relative to the mass of all the solvents contained in the liquid composition, from the viewpoints of viscosity and film formability.

The liquid composition of the present invention may comprise, in addition to the above-described polymer compound of the present invention, a low-molecular weight light-emitting material, a hole transport material, an electron transport material, a stabilizer, an additive for controlling the viscosity and/or the surface tension, an antioxidant, and the like. As each of these optional components, one kind thereof may be used alone, or a combination of two or more kinds thereof may be used.

Examples of the low-molecular weight light-emitting material which may be contained in the liquid composition of the present invention include: naphthalene derivatives; anthracene; anthracene derivatives; perylene, perylene derivatives; polymethine-based dyes; xanthene-based dyes; coumarin-based dyes; cyanine-based dyes; metal complexes having 8-hydroxyquinoline as a ligand; metal complexes having a 8-hydroxyquinoline derivative as a ligand; other metal complexes capable of light emission; aromatic amines; tetraphenylcyclopentadiene; tetraphenylcyclopentadiene derivatives; tetraphenylcyclobutadiene; tetraphenylcyclobutadiene derivatives; materials capable of light emission such as stilbene-based, silicon-containing aromatic-based, oxazole-based, furoxan-based, thiazole-based, tetraarylmethane-based, thiadiazole-based, pyrazole-based, metacyclophane-based, acetylene-based low-molecular weight compounds and the like. Examples of such low-molecular weight light-emitting materials include known compound such as those described in Japanese Unexamined Patent Application Publication No. Sho 57-51781, Japanese Unexamined Patent Application Publication No. Sho 59-194393, or the like.

Moreover, as the metal complex capable of light emission, a metal complex capable of light emission from a triplet excited state (i.e., a triplet light-emitting complex: for example, complexes from which phosphorescent light emission is observed, and from which fluorescent light is observed in addition to the phosphorescent light emission are included) may be used. Known compounds which have been conventionally utilized as low-molecular weight-type EL materials capable of light emission can be used as appropriate as the metal complex capable of light emission from a triplet excited state. Examples of such triplet light-emitting complexes include those disclosed in Nature, (1998), 395, 151, Appl. Phys. Lett. (1999), 75(1), 4, Proc. SPIE-Int. Soc. Opt. Eng. (2001), 4105 (Organic Light-Emitting Materials and Devices IV), 119, J. Am. Chem. Soc. , (2001), 123, 4304, Appl. Phys. Lett. , (1997), 71 (18), 2596, Syn. Met., (1998), 94 (1), 103, Syn. Met., (1999), 99 (2), 1361, Adv. Mater., (1999), 11 (10), 852, and the like.

Examples of the hole transport material which may be contained in the liquid composition of the present invention include: polyvinylcarbazole and derivatives thereof; polysilane and derivatives thereof; polysiloxane derivatives each having an aromatic amine in its side chain or main chain; pyrazoline derivatives; arylamine derivatives; stilbene derivatives; triphenyldiamine derivatives; polyaniline and derivatives thereof; polythiophene and derivatives thereof; polypyrrole and derivatives thereof; poly(p-phenylene vinylene) and derivatives thereof; poly(2,5-thienylene vinylene ) and derivatives thereof; and the like.

Examples of the electron transport material which may be contained in the liquid composition of the present invention include: oxadiazole derivatives; anthraquinodimethane and derivatives thereof; benzoquinone and derivatives thereof; naphtoquinone and derivatives thereof; anthraquinone and derivatives thereof; tetracyanoanthraquinodimethane and derivatives thereof; fluorenone derivatives; diphenyldicyanoethylene and derivatives thereof; diphenoquinone derivatives; metal complexes of 8-hydroxyquinoline and metal complexes of derivatives of 8-hydroxyquinoline; polyquinoline and derivatives thereof; polyquinoxaline and derivatives thereof; polyfluorene and derivatives thereof; and the like.

Moreover, examples of the stabilizer which may be contained in the liquid composition of the present invention include phenol-based antioxidants, phosphorus-based antioxidants, and the like.

As the additive which may be contained in the liquid composition of the present invention for controlling the viscosity and/or the surface tension, an appropriate combination of, for example, a high-molecular weight compound (thickening agent) or a poor solvent for increasing the viscosity, a low-molecular weight compound for decreasing the viscosity, a surfactant for reducing the surface tension and the like may be used. The high-molecular weight compound (thickening agent) may be any high-molecular weight compound, as long as the high-molecular weight compound does not inhibit light emission or charge transportation. A high-molecular weight compound soluble in the solvent of the liquid composition is preferable as the high-molecular weight compound. Examples of such a high-molecular weight compound include high-molecular weight polystyrenes, high-molecular weight polymethyl methacrylate, and the like. Moreover, the high-molecular weight compound has a polystyrene equivalent weight average molecular weight of preferably 500,000 or more, and more preferably 1,000,000 or more. A poor solvent can be used as the thickening agent.

The antioxidant which may be contained in the liquid composition of the present invention may be any antioxidant, as long as the antioxidant does not inhibit the light emission or the charge transportation. An antioxidant soluble in the solvent in the liquid composition is preferable as the antioxidant. Examples of such an antioxidant include phenol-based antioxidants, phosphorus-based antioxidants, and the like. The use of such an antioxidant makes it possible to improve the storage stability of the polymer compound and the solvent.

When the liquid composition of the present invention comprises the hole transport material, the ratio of the hole transport material in the liquid composition is preferably 1% by mass to 80% by mass, and more preferably 5% by mass to 60% by mass. Moreover, when the liquid composition of the present invention comprises the electron transport material, the ratio of the electron transport material in the liquid composition is preferably 1% by mass to 80% by mass, and more preferably 5% by mass to 60% by mass.

It is possible to efficiently produce an organic layer in a polymer light-emitting device by using such a liquid composition of the present invention and forming a film therefrom. When a film of such an organic layer in a polymer light-emitting device is formed, it is only necessary that the liquid composition of the present invention is applied and thereafter the solvent is removed by drying. The same method can be adopted in cases where a charge transport material or a light-emitting material is mixed. Hence, this film formation is extremely advantageous for production. The drying may be performed in a state where the temperature is raised by heating to approximately 50 °C to 150°C, and the drying may be performed in vacuo at approximately 10⁻³ Pa.

As a film formation method using the liquid composition of the present invention, an application method such as a spin coating method, a casting method, a micro gravure coating method, a gravure coating method, a bar coating method, a roll coating method, a wire bar coating method, a dip coating method, a slit coating method, a capillary coating method, a spray coating method, a screen printing method, a flexo printing method, an offset printing method, an ink jet printing method, or a nozzle coating method.

### [Thin Film]

Next, a thin film of the present invention will be described. The thin film of the present invention comprises the above-described polymer compound. Applications of such a thin film of the present invention are not particularly limited; however, the thin film of the present invention is preferably used as a light emitting thin film, an electroconductive thin film, an organic semiconductor thin film, or the like. A light emitting thin film formed of the thin film of the present invention has a quantum yield of light emission of preferably 50% or more, more preferably 60% or more, and further preferably 70% or more, from the viewpoints of luminance and light emission voltage of the device, and the like. The electroconductive thin film preferably has a surface resistance of 1 KΩ/□ or less. The electrical conductivity can be increased by doping a Lewis acid, an ionic compound, or the like into the thin film. The surface resistance is more preferably 100 Ω/□ or less, and further preferably 10 Ω/□ or less. Moreover, in the organic semiconductor thin film, the larger one of the electron mobility and the hole mobility is preferably 10⁻⁵ cm²/Vs or more, more preferably 10⁻³ cm²/Vs or more, and further preferably 10⁻¹ cm²/Vs or more. By using such an organic semiconductor thin film, an organic transistor can be fabricated. Specifically, an organic transistor can be obtained by forming the organic semiconductor thin film on a Si substrate on which an insulating film of SiO₂ or the like and a gate electrode, and forming a source electrode and a drain electrode by using Au or the like.

### [Polymer Light-Emitting Device]

Next, a polymer light-emitting device of the present invention will be described. The polymer light-emitting device of the present invention includes an organic layer containing the polymer compound of the present invention, said organic layer being located between electrodes including an anode and a cathode. Examples of such an organic layer include a light emitting layer, an electron transporting layer, and a hole transporting layer. In such a polymer light-emitting device, the organic layer is more preferably a light emitting layer. Note that, when the polymer compound of the present invention is used as a light-emitting material of a polymer light-emitting device, the purity of the polymer compound has an effect on the light emission characteristics. Accordingly, monomers before polymerization are preferably purified by a method such as distillation or sublimation purification, or recrystallization, and then polymerized. After the synthesis, it is preferable to perform purification treatment such as reprecipitation purification, fractionation by chromatography, or the like.

Examples of the polymer light-emitting device of the present invention include: a polymer light-emitting device including an electron transporting layer provided between the cathode and a light emitting layer; a polymer light-emitting device including a hole transporting layer provided between the anode and a light emitting layer; a polymer light-emitting device including an electron transporting layer provided between the cathode and a light emitting layer and a hole transporting layer provided between the anode and the light emitting layer; and the like.

Examples of such polymer light-emitting devices include those having the following structures a) to d):
a) Anode/light emitting layer/cathode
b) Anode/hole transporting layer/light emitting layer/cathode
c) Anode/light emitting layer/electron transporting layer/cathode
d) Anode/hole transporting layer/light emitting layer/electron transporting layer/cathode.
(Here, "/" indicates that the layers are stacked while being adjacent to each other, and hereinafter the same shall apply.)

Here, the light emitting layer is a layer having a light emitting function, the hole transporting layer is a layer having a hole transporting function, and the electron transporting layer is a layer having an electron transporting function. Note that, the electron transporting layer and the hole transporting layer are collectively referred to as charge transporting layers. The light emitting layer, the hole transporting layer, and the electron transporting layer each may be independently formed by using two or more layers.

A method of film formation of such a light emitting layer is not particularly limited, and an example thereof is a method in which the liquid composition of the present invention is used and this liquid composition is formed into a film. As specific film formation methods, application methods such as a spin coating method, a casting method, a micro gravure coating method, a gravure coating method, a bar coating method, a roll coating method, a wire bar coating method, a dip coating method, a slit coating method, a capillary coating method, a spray coating method, a screen printing method, a flexo printing method, an offset printing method, an ink jet printing method, a nozzle coating method can be used as appropriate. Note that, when the method in which the liquid composition of the present invention is used and this liquid composition is formed into a film is used for fabricating the polymer light-emitting device of the present invention, it is only necessary that the liquid composition of the present invention is applied and thereafter the solvent is removed by drying. When the method is used, the production efficiency is improved, and it becomes advantageous for production. Note that the same method can be adopted even when a charge transport material or a light-emitting material is mixed into the liquid composition of the present invention, and it becomes very advantageous for the production of the polymer light-emitting device.

An optimum value of the film thickness of the light emitting layer varies depending on the material used, and the film thickness may be set as appropriate so that the drive voltage and the light emission efficiency may take moderate values. The film thickness is preferably 1 nm to 1 µm, more preferably 2 nm to 500 nm, and further preferably 5 nm to 200 nm.

In the polymer light-emitting device of the present invention, a light-emitting material other than the polymer compound of the present invention may be mixed in the light emitting layer for use. Note that, even when the light-emitting material is mixed, the same method as the above mentioned film formation method can be adopted. In the polymer light-emitting device of the present invention, a light emitting layer containing a light-emitting material other than the above-described polymer compound may be stacked on the light emitting layer containing the above-described polymer compound.

As the light-emitting material other than the polymer compound of the present invention, known light-emitting materials can be used. For example, light-emitting materials formed of low-molecular weight compounds, such as: naphthalene derivatives; anthracene and derivatives thereof; perylene and derivatives thereof; dyes such as polymethine-based, xanthene-based, coumarin-based, and cyanine-based dyes; metal complexes of 8-hydroxyquinoline and metal complexes of derivatives of 8-hydroxyquinoline; aromatic amines; tetraphenylcyclopentadiene and derivatives thereof; tetraphenylbutadiene and derivatives thereof; and the like can be used. Specifically, known light-emitting materials such as those described in Japanese Unexamined Patent Application Publication Nos. Sho 57-51781 and Sho 59-194393 can be used. Light-emitting materials formed of metal complexes such as metal complexes capable of light emission from a triplet excited state (i.e., triplet light-emitting complexes: for example, complexes from which phosphorescent light emission is observed, and from which fluorescent light is observed in addition to the phosphorescent light emission are included) may be used. For example, those conventionally utilized as low-molecular weight EL materials capable of light emission can be used as appropriate. Examples of such triplet light-emitting complexes include those disclosed in Nature, (1998), 395, 151, Appl. Phys. Lett. (1999), 75(1), 4, Proc. SPIE-Int. Soc. Opt. Eng. (2001), 4105 (Organic Light-Emitting Materials and Devices IV), 119, J. Am. Chem. Soc., (2001), 123, 4304, Appl. Phys. Lett., (1997), 71(18), 2596, Syn. Met., (1998), 94(1), 103, Syn. Met., (1999), 99(2), 1361, Adv. Mater., (1999), 11(10), 852, and the like.

Examples of hole transport materials used when the polymer light-emitting device of the present invention has a hole transporting layer include: polyvinylcarbazole and derivatives thereof; polysilane and derivatives thereof; polysiloxane derivatives having aromatic amines in their side chains or main chains; pyrazoline derivatives; arylamine derivatives; stilbene derivatives; triphenyldiamine derivatives; polyaniline and derivatives thereof; polythiophene and derivatives thereof; polypyrrole and derivatives thereof; poly(p-phenylene vinylene) and derivatives thereof; poly(2,5-thienylene vinylene) and derivatives thereof; and the like. Specific examples of the hole transport materials include those described in Japanese Unexamined Patent Application Publication Nos. Sho 63-70257 and Sho 63-175860, Japanese Unexamined Patent Application Publication Nos. Hei 2-135359, Hei 2-135361, Hei 2-209988, Hei 3-37992, and Hei 3-152184, and the like.

Among these hole transport materials, polymer hole transport materials such as: polyvinylcarbazole and derivatives thereof; polysilane and derivatives thereof; polysiloxane derivatives having aromatic amine compounds group in their side chains or main chains; polyaniline and derivatives thereof; polythiophene and derivatives thereof; poly(p-phenylene vinylene) and derivatives thereof; and poly(2,5-thienylene vinylene) and derivatives thereof are preferable. Further preferable are: polyvinylcarbazole and derivatives thereof; polysilane and derivatives thereof; and polysiloxane derivatives having aromatic amines in their side chains or main chains. In a case of a low-molecular weight hole transport material, the hole transport material is preferably dispersed in a polymer binder for use.

As the polyvinylcarbazole and derivatives thereof, for example, those obtained from a vinyl monomer by cation polymerization or radical polymerization can be suitably used.

Examples of the polysilane and derivatives thereof include compounds described in Chem. Rev. Vol. 89, p. 1359 (1989) and British Patent No. GB2300196, and the like. As synthesis methods of such polysilane and derivatives thereof, methods described therein can be used, and the Kipping method is particularly suitably used.

Since the siloxane skeletal structure of the polysiloxane and derivatives thereof has almost no hole transporting ability, one having a structure of any of the above-described low-molecular weight hole transport materials in its side chain or main chain is suitably used. A particular example is one having an aromatic amine capable of transporting holes in its side chain or main chain.

A film formation method of the hole transporting layer is not limited. An example thereof for the low-molecular weight hole transport material is a method of film formation from a mixture solution with the polymer binder. An example thereof for the polymer hole transport material is a method of film formation from a solution.

A solvent used for such film formation from a solution is not particularly limited, as long as the solvent is capable of dissolving the hole transport material. Examples of such a solvent include: chlorine-containing solvents such as chloroform, methylene chloride and dichloroethane; ether-based solvent such as tetrahydrofuran; aromatic hydrocarbon-based solvents such as toluene and xylene; ketone-based solvents such as acetone and methyl ethyl ketone; ester-based solvents such as ethyl acetate, butyl acetate and ethyl cellosolve acetate.

As specific film formation methods of the hole transporting layer, application methods such as: a spin coating method, a casting method, a micro gravure coating method, a gravure coating method, a bar coating method, a roll coating method, a wire bar coating method, a dip coating method, a slit coating method, a capillary coating method, a spray coating method, a screen printing method, a flexo printing method, an offset printing method, an ink jet printing method, and a nozzle coating method, each using the solution, can be used.

As the polymer binder which is mixed for such film formation, one not extremely inhibiting charge transportation is preferable, and one not strongly absorbing visible light is suitably used. Examples of such a polymer binder include poly carbonate, poly acrylate, polymethyl acrylate, polymethyl methacrylate, polystyrene, polyvinyl chloride, polysiloxane, and the like.

Note that, when the film formation of the hole transporting layer is performed, the liquid composition of the present invention containing the hole transport material may be used and the film may be formed therefrom. When the liquid composition of the present invention is used in this way, it is only necessary that this liquid composition is applied and the solvent is removed by drying. This tends to improve the production efficiency and hence tends to be advantageous for the production.

An optimum value of the film thickness of the hole transporting layer varies depending on the material used, and the film thickness may be set as appropriate so that the driving voltage and the light emission efficiency may take moderate values. However, at least enough thickness to prevent formation of a pinhole is necessary. Too large a thickness increases the driving voltage of the device, and hence is unfavorable. Accordingly, the film thickness of the hole transporting layer is preferably 1 nm to 1 µm, more preferably 2 nm to 500 nm, and further preferably 5 nm to 200 nm.

A known electron transport material can be used as the electron transport material used when the polymer light-emitting device of the present invention comprises an electron transporting layer, and examples of the electron transport material include: oxadiazole derivatives; anthraquinodimethane and derivatives thereof; benzoquinone and derivatives thereof; naphtoquinone and derivatives thereof; anthraquinone and derivatives thereof; tetracyanoanthraquinodimethane and derivatives thereof; fluorenone derivatives; diphenyldicyanoethylene and derivatives thereof; diphenoquinone derivatives; metal complexes of 8-hydroxyquinoline and metal complexes of derivatives of 8-hydroxyquinoline, polyquinoline and derivatives thereof; polyquinoxaline and derivatives thereof; polyfluorene and derivatives thereof; and the like. Specific examples of the electron transport material include: those described in Japanese Unexamined Patent Application Publication Nos. Sho 63-70257, Sho 63-175860, and Japanese Unexamined Patent Application Publication Nos. Hei 2-135359, Hei 2-135361, Hei 2-209988, Hei 3-37992, and Hei 3-152184, and the like.

Among such electron transport materials, oxadiazole derivatives; benzoquinone and derivatives thereof; anthraquinone and derivatives thereof; and metal complexes of 8-hydroxyquinoline and metal complexes of derivatives of 8-hydroxyquinoline; polyquinoline and derivatives thereof; polyquinoxaline and derivatives thereof; polyfluorene and derivatives thereof are preferable. 2-(4-biphenylyl)-5-(4-t-butylphenyl)-1,3,4-oxadiazole, benzoquinone, anthraquinone, tris(8-quinolinol) aluminum, polyquinoline are further preferable.

A film formation method of such an electron transporting layer is not particularly limited. Examples thereof for the low-molecular weight electron transport material include: vacuum deposition methods using a powder; methods of film formation from a solution or a melt state, and examples for the polymer electron transport material include methods of film formation from a solution or a melt state. For the film formation from a solution or a melt state, a polymer binder may be used in combination.

A solvent used for such film formation of the electron transporting layer from a solution is not particularly limited, as long as the solvent is capable of dissolving the electron transport material and/or the polymer binder. Examples of such a solvent include: chlorine-containing solvents such as chloroform, methylene chloride and dichloroethane; ether-based solvent such as tetrahydrofuran; aromatic hydrocarbon-based solvents such as toluene and xylene; ketone-based solvents such as acetone and methyl ethyl ketone; ester-based solvents such as ethyl acetate, butyl acetate and ethyl cellosolve acetate; and the like.

As the film formation methods from a solution or a melt state, application methods such as a spin coating method, a casting method, a micro gravure coating method, a gravure coating method, a bar coating method, a roll coating method, a wire bar coating method, a dip coating method, a slit coating method, a capillary coating method, a spray coating method, a screen printing method, a flexo printing method, an offset printing method, an ink jet printing method and a nozzle coating method can be used.

Moreover, as the polymer binder which is mixed for such film formation, one not extremely inhibiting charge transportation is preferable, and one not strongly absorbing visible light is suitably used. Examples of such a polymer binder include: poly(N-vinylcarbazole); polyaniline and derivatives thereof; polythiophene and derivatives thereof; poly(p-phenylene vinylene) and derivatives thereof; poly(2,5-thienylene vinylene) and derivatives thereof; polycarbonate; polyacrylate; polymethyl acrylate; polymethyl methacrylate, polystyrene, polyvinyl chloride; polysiloxane; and the like.

An optimum value of the film thickness of such an electron transporting layer varies depending on the material used, and the film thickness may be set as appropriate so that the driving voltage and the light emission efficiency may take moderate values. However, at least enough thickness to prevent formation of a pinhole is necessary. Too large a thickness increases the driving voltage of the device, and hence is unfavorable. Accordingly, the film thickness of the electron transporting layer is preferably 1 nm to 1 µm, more preferably 2 nm to 500 nm, and further preferably 5 nm to 200 nm.

Note that, of charge transporting layers provided adjacent to an electrode, those having a function to improve charge injection efficiency through the electrode and having an effect to decrease the driving voltage of the device may be particularly referred to as charge injection layers (hole injection layers and electron injection layers), in general.

For the purposes of improving adhesion with an electrode or charge injection through the electrode, the polymer light-emitting device of the present invention may be provided with a charge injection layer or an insulating layer as described above (more preferably, an insulating layer having a film thickness of 2 nm or less) adjacent to the electrode. For the purposes of improving adhesion at an interface, preventing mixing, or other purposes, a thin buffer layer may be interposed at an interface of the charge transporting layer or the light emitting layer. The stacking order, the number, and the thicknesses of layers to be stacked may be set as appropriate, with the light emission efficiency and the device lifetime taken into consideration.

In the present invention, examples of the polymer light-emitting device provided with the charge injection layer (the electron injection layer, or the hole injection layer) include: a polymer light-emitting device provided with the charge injection layer adjacent to the cathode; and a polymer light-emitting device provided with the charge injection layer adjacent to the anode. Such polymer light-emitting devices have, for example, the following structures e) to p):
e) Anode/charge injection layer/light emitting layer/cathode
f) Anode/light emitting layer/charge injection layer/cathode
g) Anode/charge injection layer/light emitting layer/charge injection layer/cathode
h) Anode/charge injection layer/hole transporting layer/light emitting layer/cathode
i) Anode/hole transporting layer/light emitting layer/charge injection layer/cathode
j) Anode/charge injection layer/hole transporting layer/light emitting layer/charge injection layer/cathode
k) Anode/charge injection layer/light emitting layer/electron transporting layer/cathode
l) Anode/light emitting layer/electron transporting layer/charge injection layer/cathode
m) Anode/charge injection layer/light emitting layer/electron transporting layer/charge injection layer/cathode
n) Anode/charge injection layer/hole transporting layer/light emitting layer/electron transporting layer/cathode
o) Anode/hole transporting layer/light emitting layer/electron transporting layer/charge injection layer/cathode
p) Anode/charge injection layer/hole transporting layer/light emitting layer/electron transporting layer/charge injection layer/cathode.
   Specific examples of such charge injection layers include: a layer containing an electroconductive polymer; a layer provided between the anode and the hole transporting layer and containing a material having an ionization potential which takes an intermediate value between those of the anode material and the hole transport material contained in the hole transporting layer; a layer provided between the cathode and the electron transporting layer and containing a material having an electron affinity which takes an intermediate value between those of the cathode material and the electron transport material contained in the electron transporting layer; and the like.
   When the above-described charge injection layer is the layer containing an electroconductive polymer, the electroconductive polymer has an electrical conductivity of preferably 10⁻⁵ S/cm or more but 10³ S/cm or less. To reduce the leak current between pixels of the light emission, the electrical conductivity is more preferably 10⁻⁵ S/cm or more but 10² S/cm or less, and further preferably 10⁻⁵ S/cm or more but 10¹ S/cm or less.
   Moreover, to make the electrical conductivity of the electroconductive polymer 10⁻⁵ S/cm or more but 10³S/cm or less, the electroconductive polymer is preferably doped with an appropriate amount of ions. The kind of the ions doped into the electroconductive polymer is anions for the hole injection layer, and cations for the electron injection layer. Examples of such anions include polystyrenesulfonate ions, alkylbenzenesulfonate ions and camphorsulfonate ions, and the like. Examples of the cations include lithium ions, sodium ions, potassium ions, tetrabutylammonium ions, and the like.
   The film thickness of such a charge injection layer is, for example, 1 nm to 100 nm, and preferably 2 nm to 50 nm.
   A material used for the charge injection layer may be selected as appropriate on the basis of the relationship with the materials of the electrode and the adjacent layer, and examples thereof include: polyaniline and derivatives thereof; polythiophene and derivatives thereof; polypyrrole and derivatives thereof; polyphenylene-vinylene and derivatives thereof; polythienylene-vinylene and derivatives thereof; polyquinoline and derivatives thereof; polyquinoxaline and derivatives thereof; electroconductive polymers such as polymers each containing an aromatic amine structure in the main chain or a side chain; metallophthalocyanines (copper phthalocyanine and the like); carbon; and the like.
   The insulating layer has a function to facilitate the charge injection. Examples of the material of such an insulating layer include metal fluorides, metal oxides, organic insulating materials, and the like. The average film thickness of such an insulating layer is preferably 2 nm or less. Examples of the polymer light-emitting device including the insulating layer with a film thickness of 2 nm or less and being suitable as the polymer light-emitting device of the present invention include; a polymer light-emitting device provided with the insulating layer with a film thickness of 2 nm or less adjacent to the cathode; and a polymer light-emitting device provided with the insulating layer with a film thickness of 2 nm or less adjacent to the anode. Such polymer light-emitting devices have, for example, the following structures q) to ab) :
q) Anode/insulating layer with a film thickness of 2 nm or less/light emitting layer/cathode
r) Anode/light emitting layer/insulating layer with a film thickness of 2 nm or less/cathode
s) Anode/insulating layer with a film thickness of 2 nm or less/light emitting layer/insulating layer with a film thickness of 2 nm or less/cathode
t) Anode/insulating layer with a film thickness of 2 nm or less/hole transporting layer/light emitting layer/cathode
u) Anode/hole transporting layer/light emitting layer/insulating layer with a film thickness of 2 nm or less/cathode
v) Anode/insulating layer with a film thickness of 2 nm or less/hole transporting layer/light emitting layer/insulating layer with a film thickness of 2 nm or less/cathode
w) Anode/insulating layer with a film thickness of 2 nm or less/light emitting layer/electron transporting layer/cathode
x) Anode/light emitting layer/electron transporting layer/insulating layer with a film thickness of 2 nm or less/cathode
y) Anode/insulating layer with a film thickness of 2 nm or less/light emitting layer/electron transporting layer/insulating layer with a film thickness of 2 nm or less/cathode
z) Anode/insulating layer with a film thickness of 2 nm or less/hole transporting layer/light emitting layer/electron transporting layer/cathode
aa) Anode/hole transporting layer/light emitting layer/electron transporting layer/insulating layer with a film thickness of 2 nm or less/cathode
ab) Anode/insulating layer with a film thickness of 2 nm or less/hole transporting layer/light emitting layer/electron transporting layer/insulating layer with a film thickness of 2 nm or less/cathode.

Such a polymer light-emitting device is generally formed on a supporting substrate. The substrate on which the polymer light-emitting device of the present invention is formed needs to be unchanged in the formation of the electrodes and formation of the layers of organic compounds. Examples of the substrate include substrates of glass, plastics, polymer films, silicon, and the like. When the substrate is opaque, the electrode on the other side is preferably transparent or translucent.

In the polymer light-emitting device of the present invention, it is preferable that at least one of the electrodes including the anode and the cathode be transparent or translucent, and it is more preferable that the electrode on the anode side be transparent or translucent. An electroconductive metal oxide film, a translucent metal thin film, or the like is suitably used as the material for such an anode. Specific examples of the material of such an anode include; films (for example NESA) formed by using electroconductive glasses formed of indium oxide, zinc oxide, tin oxide, or composites thereof such as indium•tin•oxide (ITO) and indium•zinc•oxide; gold; platinum; silver; copper; and the like. ITO, indium·zinc·oxide, tin oxide are preferable. Examples of formation method of such an anode include a vacuum deposition method, a sputtering method, an ion plating method, a plating method, and the like. For such an anode, an organic transparent electroconductive film of polyaniline or a derivative thereof, polythiophene or a derivative thereof, or the like may be used.

The film thickness of such an anode can be selected as appropriate in consideration of the light transmission properties and the electrical conductivity. The film thickness is preferably 10 nm to 10 µm, more preferably 20 nm to 1 µm, and further preferably 50 nm to 500 nm.

To facilitate the charge injection, a layer formed of a phthalocyanine derivative, an electroconductive polymer, carbon, or the like or a layer formed of a metal oxide, a metal fluoride, an organic insulating material, or the like may be provided on the anode. The average film thickness of such a layer formed of a metal oxide, a metal fluoride, an organic insulating material, or the like is preferably 2 nm or less.

As the material of the cathode used in the polymer light-emitting device of the present invention, a material with a small work function is preferable. Examples of such a material of the cathode include: metals such as lithium, sodium, potassium, rubidium, caesium, beryllium, magnesium, calcium, strontium, barium, aluminum, scandium, vanadium, zinc, yttrium, indium, cerium, samarium, europium, terbium and ytterbium; alloys of two or more of these metals; alloys of one or more of these metals and one or more of gold, silver, platinum, copper, manganese, titanium, cobalt, nickel, tungsten, and tin; graphite and graphite intercalation compounds; and the like. Examples of the alloys include a magnesium-silver alloy, a magnesium-indium alloy, a magnesium-aluminum alloy, an indium-silver alloy, a lithium-aluminum alloy, a lithium-magnesium alloy, a lithium-indium alloy, a calcium-aluminum alloy, and the like. The cathode may have a stacked structure of two or more layers.

The film thickness of such a cathode can be selected as appropriate in consideration of the electrical conductivity and the durability, and the film thickness is preferably 10 nm to 10 µm, more preferably 20 nm to 1 µm, and further preferably 50 nm to 500 nm.

As a formation method of such a cathode, a vacuum deposition method, a sputtering method, a lamination method with which a metal thin film is thermocompression-bonded, or the like is used. A layer formed of an electroconductive polymer or a layer formed of a metal oxide, a metal fluoride, an organic insulating material, or the like (more preferably, a layer thereof with an average film thickness of 2 nm or less) may be provided between the cathode and a layer of an organic compound. After formation of the cathode, a protection layer for protecting the obtained polymer light-emitting device may be mounted. To use the polymer light-emitting device of the present invention stably for a long period, the protection layer and/or a protection cover are preferably mounted thereon for protection of the device from the outside.

As such a protection layer, a polymer compound, a metal oxide, a metal fluoride, a metal boride, or the like can be used. As the protection cover, for example, a glass plate; a plastic plate whose surface is subjected to a treatment which reduces the water permeability thereof; or the like can be used. When such a protection cover is mounted, a method is suitably used in which the device substrate and the protection cover are laminated to each other by using a thermosetting resin or a light setting resin for sealing the device. Maintaining a gap by using a spacer easily prevents the device from being damaged. Moreover, filling an inert gas such as nitrogen or argon into the gap formed by such a spacer makes it possible to prevent the cathode from being oxidized. Furthermore, providing a desiccant such as barium oxide in the gap easily prevents water adsorbed in a process for the production from damaging the device. Of these measures, any one or more measures are preferably taken.

### [Surface Light Source and Display Device]

Next, a surface light source and a display device of the present invention will be described. The surface light source of the present invention comprises the above-described polymer light-emitting device of the present invention. The display device of the present invention also comprises the above-described polymer light-emitting device of the present invention. Such a display device is not particularly limited, and examples thereof include segment display devices, dot matrix display devices, liquid crystal display devices (one using the polymer light-emitting device of the present invention as the backlight thereof and the like), and the like.

In order to obtain a planar light emission by the surface light source of the present invention comprising the polymer light-emitting device of the present invention, a planar anode and a planar cathode may be arranged so as to overlap with each other. In order to obtain a patterned light emission by using the polymer light-emitting device of the present invention for production of the display device of the present invention, there are a method in which a mask provided with a patterned window is provided on a surface of the planar light-emitting device; a method in which parts of the organic compound layer corresponding to intended non-light emission parts are formed in extremely large thicknesses to thereby achieve substantially non-light emission; a method in which one of the anode or the cathode, or both electrodes are formed as patterned ones; and the like. By forming a pattern by such a method, and arranging several electrodes so as to be independently turned on and off, a segment-type display device capable of displaying numeric characters, letters, simple symbols, and the like can be obtained. Moreover, to render the polymer light-emitting device of the present invention a dot matrix device, the anode and the cathode may be both formed in stripe shapes and arranged so as to be perpendicular to each other. A method for selectively applying multiple kinds of polymer compounds with different light emission colors, or a method using a color filter or a fluorescent conversion filter makes it possible to achieve partial color display and multicolor display. Such a dot matrix device can be driven passively, and may be driven actively in combination with a TFT or the like. The display device formed of the polymer light-emitting device of the present invention can be used as a display device for a computer, a TV, a mobile terminal, a mobile phone, a car navigation system, a viewfinder of a video camera, or the like.

The surface light source of the present invention can be formed into a self emitting and thin type, and can be suitably used as, for example, a surface light source for a backlight of a liquid crystal display device, or a surface light source for illumination. By using a flexible substrate, the surface light source of the present invention can be used also as a curved surface light source or display device.

### [Organic Transistor]

Next, an organic transistor of the present invention will be described. The organic transistor of the present invention comprises the above-described polymer compound of the present invention. Hereinafter, the organic transistor of the present invention will be described while a polymer field-effect transistor which is a preferred embodiment of the organic transistor of the present invention is taken as an example.

The polymer field-effect transistor which is the preferred embodiment of the organic transistor of the present invention generally has a structure in which a source electrode and a drain electrode are provided in contact with an active layer formed of a polymer and in which a gate electrode is provided, with an insulating layer which is in contact with the active layer interposed therebetween. In such a polymer field-effect transistor, one of the layers needs to contain the above-described polymer compound of the present invention. In particular, a polymer field-effect transistor whose active layer contains the polymer compound of the present invention is preferable.

The polymer field-effect transistor is generally formed on a supporting substrate. The material of such a supporting substrate is not particularly limited, as long as the material does not inhibit characteristics as a field-effect transistor. For example, a glass substrate, a flexible film substrate or a plastic substrate can be used as the supporting substrate. Moreover, such a polymer field-effect transistor can be produced by known methods, for example, by a method described in Japanese Unexamined Patent Application Publication No. Hei 5-110069.

In the formation of the active layer, the polymer compound of the present invention soluble in an organic solvent is preferably used, and, more preferably, the layer is formed by using the liquid composition of the present invention, because these are extremely advantageous for the production. As such a film formation method of the active layer, an application method such as a spin coating method, a casting method, a micro gravure coating method, a gravure coating method, a bar coating method, a roll coating method, a wire bar coating method, a dip coating method, a slit coating method, a capillary coating method, a spray coating method, a screen printing method, a flexo printing method, an offset printing method, an ink jet printing method, or a nozzle coating method is used.

As the polymer field-effect transistor as described above, a polymer field-effect transistor which is sealed is preferable. By sealing the polymer field-effect transistor after production, the polymer field-effect transistor is isolated from the atmosphere, thereby making it possible to more sufficiently suppress deterioration in characteristics of the polymer field-effect transistor. Examples of such a method for sealing the polymer field-effect transistor include: a method of covering the polymer field-effect transistor by a ultraviolet light (UV) curable resin, a thermosetting resin, an inorganic SiONx film, or the like; a method of laminating a glass plate or a film to the polymer field-effect transistor by using a UV curable resin, a thermosetting resin, or the like; and the like. To perform effective isolation from the atmosphere, processes from a process subsequent to the production of the polymer field-effect transistor to the sealing process are preferably performed without exposure to the atmosphere (for example, in a dry nitrogen atmosphere, in vacuo, or in other atmospheres).

### [Solar Cell]

Next, a solar cell of the present invention will be described. The solar cell of the present invention comprises the above-described polymer compound of the present invention. Hereinafter, the solar cell of the present invention will be described, while a solid photovoltaic conversion device which is an organic photovoltaic conversion device and which utilizes the photovoltaic effect is taken as an example. This solid photovoltaic conversion device is a preferred embodiment of the solar cell of the present invention.

In the solid photovoltaic conversion device, which is the preferred embodiment of the solar cell of the present invention, the above-described polymer compound of the present invention is suitably used as a material for organic photovoltaic conversion devices, particularly for organic semiconductor layers of Schottky barrier-type device utilizing an interface between an organic semiconductor and a metal, and for organic semiconductor layers of pn heterojunction-type device utilizing an interfaces between an organic semiconductor and an inorganic semiconductor or between two organic semiconductors.

Moreover, in such a solid photovoltaic conversion device, the polymer compound of the present invention is suitably used as: an electron donor polymer or an electron acceptor polymer for bulk heterojunction-type devices in which the contact areas between donor and acceptor are increased, or an electron donor conjugated polymer (a dispersing vehicle) for organic photovoltaic conversion device using a composite system of a polymer and a low-molecular weight compound, for example, for bulk heterojunction-type organic photovoltaic conversion device of which a fullerene derivative is dispersed as an electron acceptor.

An example of the structures of such organic photovoltaic conversion devices is a structure including an ohmic electrode, for a pn heterojunction type device, e.g., a structure in which a p-type semiconductor layer is formed on an ITO, further n-type semiconductor layer is stacked thereon, and the ohmic electrode is provided thereon.

Moreover, such an organic photovoltaic conversion device is generally formed on a supporting substrate. Such a supporting substrate may be any supporting substrate, as long as the supporting substrate does not inhibit characteristics as an organic photovoltaic conversion device. The material of such a supporting substrate is not particularly limited, and, for example, a glass substrate, a flexible film substrate or a plastic substrate can be used as appropriate.

Such an organic photovoltaic conversion device can be produced by a known method such as the method described in Synth. Met., 102, 982 (1999) or the method described in Science, 270, 1789 (1995).

### Examples

Hereinafter, on the basis of Examples and Comparative Examples, the present invention will be more specifically described; however, the present invention is not limited to the following Examples.

Here, number average molecular weights and weight average molecular weights were determined, as polystyrene equivalent number average molecular weights and weight average molecular weights, by gel permeation chromatography (GPC) using tetrahydrofuran as a solvent.

### (Example 1: Synthesis of Polymer Compound (1))

First, 1.116 g of a monomer (3) represented by the following structural formula (I):

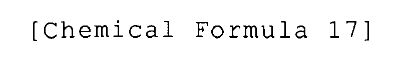

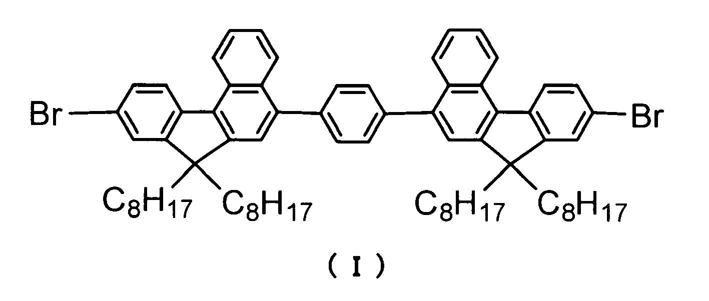

0.350 g of a monomer (10) represented by the following structural formula (II): 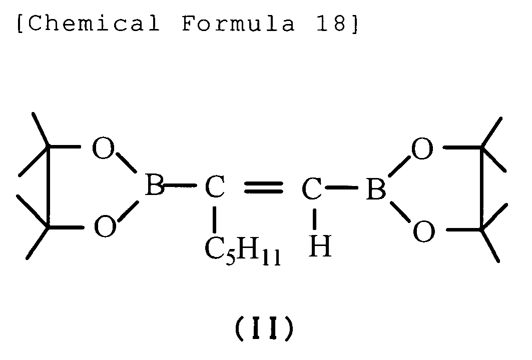 , 0.12 g of methyltrioctylammonium chloride (product name "aliquat 336 (registered trademark of Henkel Corp.)", manufactured by Sigma-Aldrich Corporation, CH₃N[(CH₂)₇CH₃]₃Cl, density: 0.884 g/ml (at 25°C)), and 1.7 mg of dichloro bis (triphenylphosphine) palladium(II) were fed into a reaction vessel, and the air inside the reaction vessel was replaced with argon gas. Next, into the reaction vessel, 15 ml of toluene which was deaerated by argon gas bubbling beforehand was added, to thereby obtain a solution. Subsequently, 5 ml of a 16.7% by mass sodium carbonate aqueous solution which was deaerated by argon gas bubbling beforehand was added dropwise to the obtained solution over several minutes. Then, the temperature was raised to the solvent reflux temperature, and reflux was performed for 12 hours for the reaction to proceed. Note that the reaction was carried out under an argon gas atmosphere.

Next, after the obtained reaction solution was cooled close to room temperature, 40 g of toluene was added to the reaction solution. This reaction solution was allowed to stand, and then phase separation was performed. Thus, a toluene solution was recovered. Subsequently, the toluene solution was filtered to remove insolubles. And then, a following process was performed two times repeatedly. The process includes a step of allowing the toluene solution to stand after washing with ion-exchanged water, and a step of recovering the phase-separated toluene solution. Next, this toluene solution was filtered, and then passed through an alumina column for purification. Thereafter, the toluene solution was poured into methanol for reprecipitation purification, and the formed precipitates were collected. Then, after washed with methanol, the obtained precipitates were vacuum-dried. Thus, 0.75 g of the polymer compound (1) was obtained.

The thus obtained polymer compound (1) had a polystyrene equivalent weight average molecular weight of 1.3×10⁴ and a polystyrene equivalent number average molecular weight of 7.4×10³. It can be estimated, from the feed, that the polymer compound (1) obtained by the production method as described above has repeating units shown in the following formulae:

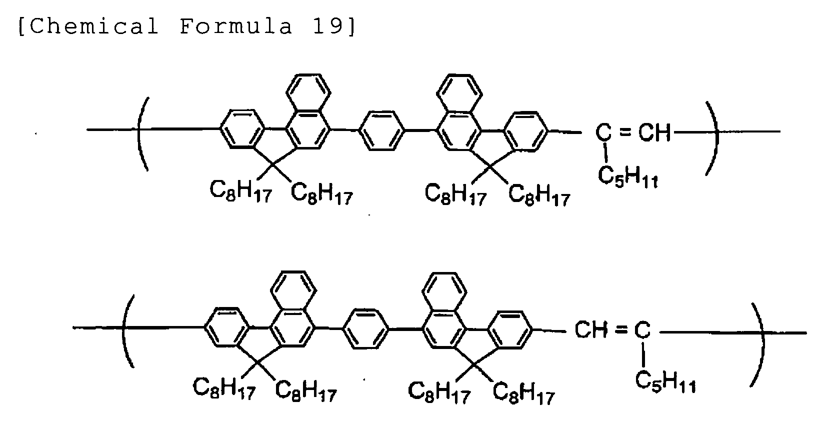

### (Example 2: Synthesis of Polymer Compound (2))

First, 1.113 g of the monomer (3), 0.355 g of a monomer (20) represented by the following structural formula (III): 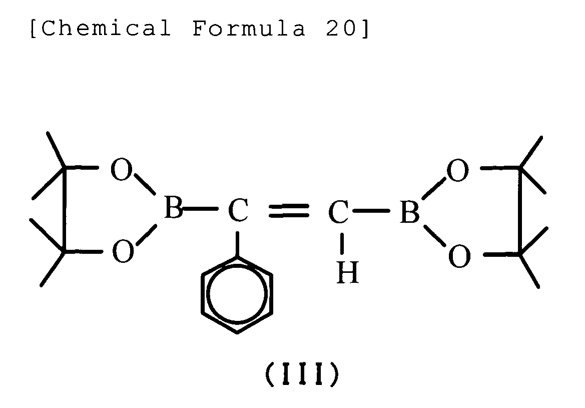 , 0.15 g of methyltrioctylammonium chloride (product name "aliquat 336 (registered trademark of Henkel Corp.)", manufactured by Sigma-Aldrich Corporation, CH₃N[(CH₂)₇CH₃]₃Cl, density: 0. 884 g/ml (at 25°C)), and 2.2 mg of dichloro bis(triphenylphosphine) palladium(II) were fed into a reaction vessel, and the air inside the reaction vessel was replaced with argon gas. Next, into the reaction vessel, 15 ml of toluene which was deaerated by argon gas bubbling beforehand was added, to thereby obtain a solution. Subsequently, 5 ml of a 16.7% by mass sodium carbonate aqueous solution which was deaerated by argon gas bubbling beforehand was added dropwise to the solution over several minutes. Then, the temperature was raised to the solvent reflux temperature, and reflux was performed for 12 hours for the reaction to proceed. Note that the reaction was carried out under an argon gas atmosphere.

Next, after the obtained reaction solution was cooled close to room temperature, 40 g of toluene was added to the reaction solution. This reaction solution was allowed to stand, and then phase separation was performed. Thus a toluene solution was recovered. Subsequently, the obtained toluene solution was filtered to remove insolubles. Next, a following process was performed two times repeatedly. The process includes a step of allowing the toluene solution to stand after washing with ion-exchanged water, and a step of recovering the phase-separated toluene solution. Next, the toluene solution was filtered, and then passed through an alumina column for purification. Thereafter, the toluene solution was poured into methanol for reprecipitation purification, and the formed precipitates were collected. Then, after washed with methanol, the obtained precipitates were vacuum-dried. Thus, 0.68 g of the polymer compound (2) was obtained.

The thus obtained polymer compound (2) had a polystyrene equivalent weight average molecular weight of 1.7×10⁴ and a polystyrene equivalent number average molecular weight of 9.8×10³. It can be estimated, from the feed, that the polymer compound (2) obtained by the production method as described above has repeating units shown in the following formulae:

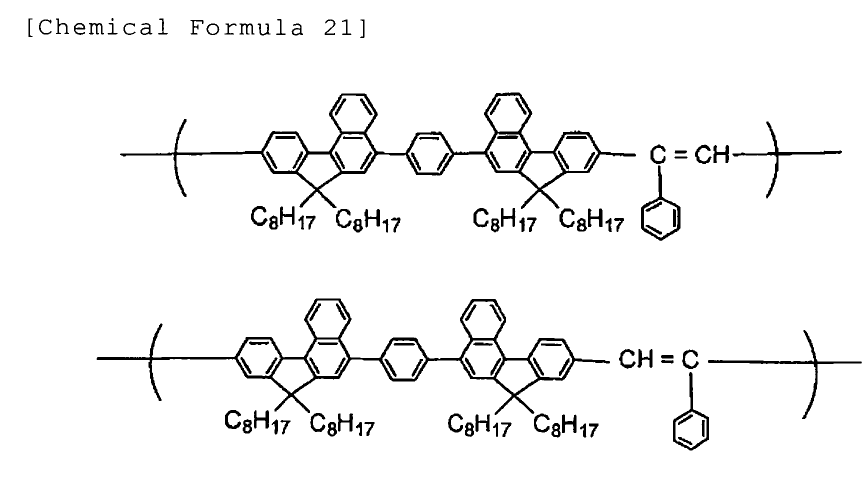

### (Example 3: Synthesis of Polymer Compound (3))

First, 0.278 g of a monomer (5) represented by the following structural formula (IV):

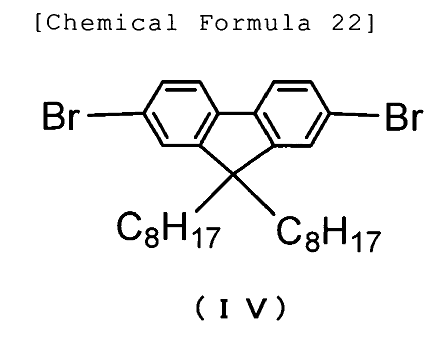

0.567 g of the monomer (3), 0.366 g of the monomer (20), 0.16 g of methyltrioctylammonium chloride (product name "aliquat 336 (registered trademark of Henkel Corp.)", manufactured by Sigma-Aldrich Corporation, CH₃N[(CH₂)₇CH₃]₃Cl, density: 0.884 g/ml (at 25°C), and 1.6 mgofdichlorobis(triphenylphosphine) palladium (II) were fed into a reaction vessel, and the air inside the reaction vessel was replaced with argon gas. Next, into the reaction vessel, 27 g of toluene which was deaerated by argon gas bubbling beforehand was added to thereby obtain a solution. Subsequently, 7 ml of a 16.7% by mass sodium carbonate aqueous solution which was deaerated by argon gas bubbling beforehand was added dropwise to the solution over several minutes. Then, the temperature was raised to the solvent reflux temperature, and reflux was performed for 14 hours for the reaction to proceed. Note that the reaction was carried out under an argon gas atmosphere.

Next, after the obtained reaction solution was cooled close to room temperature, 30 g of toluene was added to the reaction solution. This reaction solution was allowed to stand, and then phase separation was performed. Thus, a toluene solution was recovered. Subsequently, the obtained toluene solution was filtered to remove insolubles. Next, the toluene solution was washed with a 3% by mass aqueous solution of sodium N,N-diethyldithiocarbamate trihydrate, and allowed to stand. Then, the phase-separated toluene solution was recovered. Subsequently, the toluene solution was washed with a 3% by mass acetic acid aqueous solution, and allowed to stand. Then, the phase-separated toluene solution was recovered. Next, the toluene solution was washed with ion-exchanged water, and allowed to stand. Then, the phase-separated toluene solution was recovered. Next, the toluene solution was filtered, and then passed through an alumina column for purification. Thereafter, the toluene solution was poured into methanol for reprecipitation purification, and the formed precipitates were collected. Then, after washed with methanol, the obtained precipitates were vacuum-dried. Thus, 0.25 g of the polymer compound (3) was obtained.

The thus obtained polymer compound (3) had a polystyrene equivalent weight average molecular weight of 1.0×10⁴ and a polystyrene equivalent number average molecular weight of 5.9×10³. It can be estimated, from the feed, that the polymer compound (3) obtained by the production method as described above has repeating units shown in the following formulae:

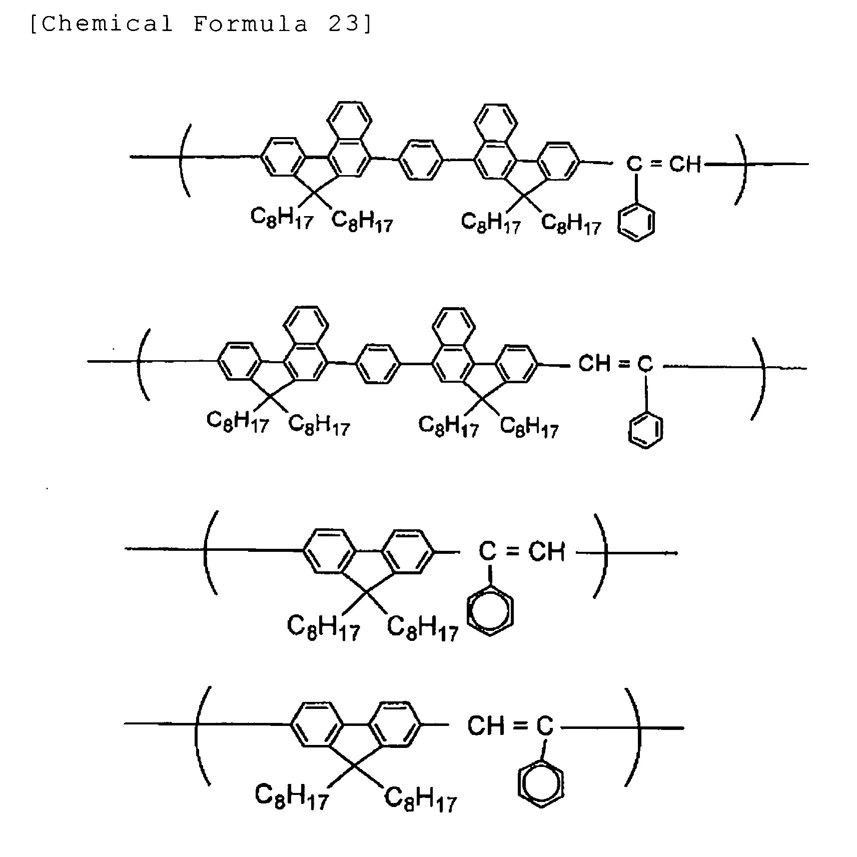

### (Example 4: Synthesis of Polymer Compound (4))

First, 0.342 g of a monomer (7) represented by the following structural formula (V): 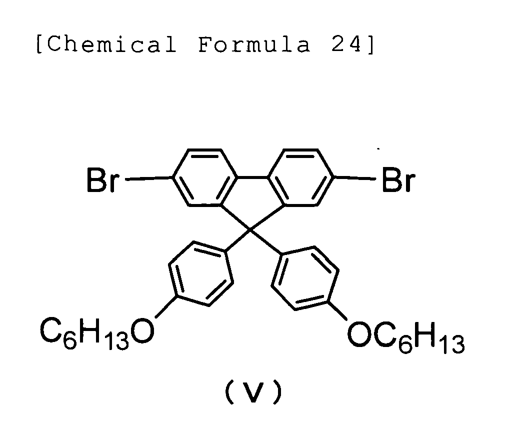 , 0.565 g of the monomer (3), 0.361 g of the monomer (10), 0.15 g of methyltrioctylammonium chloride (product name "aliquat 336 (registered trademark of Henkel Corp.)", manufactured by Sigma-Aldrich Corporation, CH₃N[(CH₂)₇CH₃]₃Cl, density: 0.884 g/ml (at 25°C), and 1.7 mg of dichloro bis(triphenylphosphine) palladium (II) were fed into a reaction vessel, and the air inside the reaction vessel was replaced with argon gas. Next, into the reaction vessel, 15 ml of toluene which was deaerated by argon gas bubbling beforehand was added, to thereby obtain a solution. Subsequently, to the solution, 5 ml of a 16.7% by mass sodium carbonate aqueous solution which was deaerated by argon gas bubbling beforehand was added dropwise over several minutes. Then, the temperature was raised to the solvent reflux temperature, and reflux was performed for 14 hours for the reaction to proceed. Note that, the reaction was carried out under an argon gas atmosphere.

Next, after the obtained reaction solution was cooled close to room temperature, 30 g of toluene was added to the reaction solution. This reaction solution was allowed to stand, and then phase separation was performed. Thus, a toluene solution was recovered. Subsequently, the obtained toluene solution was filtered to remove insolubles. Next, the toluene solution was passed through an alumina column for purification. Next, the toluene solution was poured into methanol for reprecipitation purification, and the formed precipitates were collected. Subsequently, the obtained precipitates were dissolved in toluene again. Next, the toluene solution was passed through an alumina column for purification. Thereafter, the toluene solution was poured into methanol for reprecipitation purification. Subsequently, the formed precipitates were collected. Then, after washed with methanol, the obtained precipitates were vacuum-dried. Thus, 0.27 g of the polymer compound (4) was obtained.

The thus obtained polymer compound (4) had a polystyrene equivalent weight average molecular weight of 1.4×10⁴ and a polystyrene equivalent number average molecular weight of 8.4×10³. It can be estimated, from the feed, that the polymer compound (4) obtained by the production method as described above has repeating units shown in the following formulae:

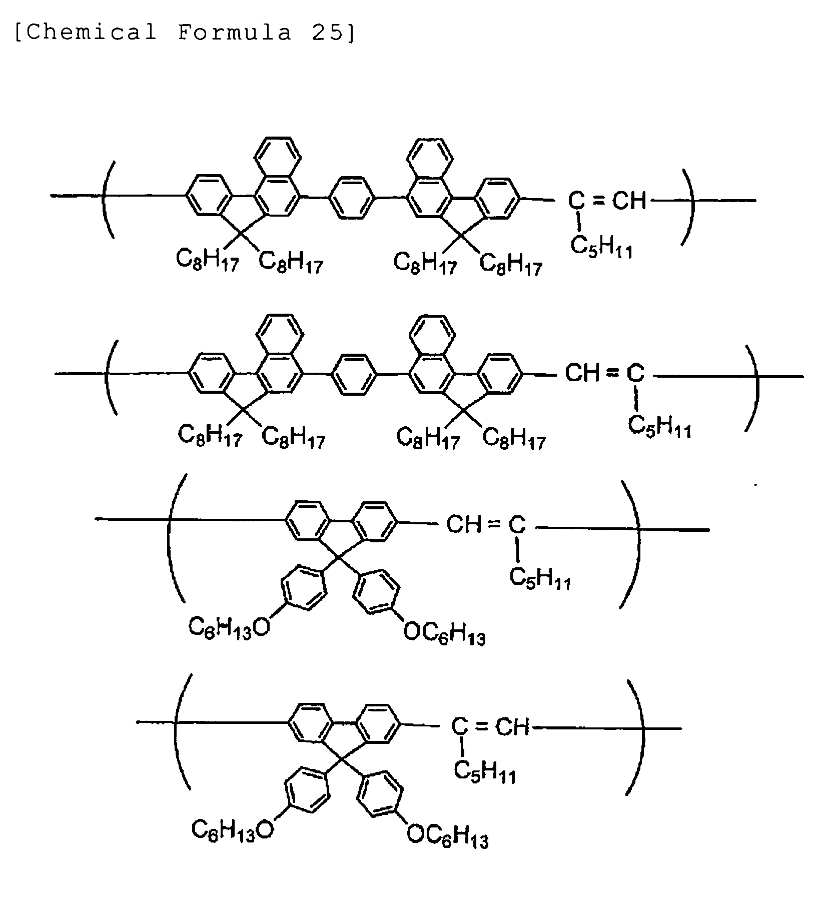

### (Comparative Example 1: Synthesis of Polymer Compound (5))

First, 0.482 g of a monomer (6) represented by the following structural formula (VI):

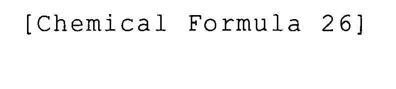

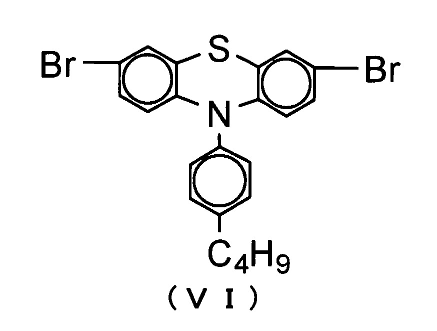

0.356 g of the monomer (20), 0.15 g of methyltrioctylammonium chloride (product name "aliquat 336 (registered trademark of Henkel Corp.)", manufactured by Sigma-Aldrich Corporation, CH₃N (CH₂)₇CH₃]₃Cl, density: 0.884 g/ml (at 25°C), and 1.5 mg of dichloro bis(triphenylphosphine) palladium(II) were fed into a reaction vessel, and the air inside the reaction vessel was replaced with argon gas. Next, into the reaction vessel, 15 ml of toluene which was deaerated by argon gas bubbling beforehand was added, to thereby obtain a solution. Subsequently, to the solution, 5 ml of a 16.7% by mass sodium carbonate aqueous solution which was deaerated by argon gas bubbling beforehand was added dropwise over several minutes. Then, the temperature was raised to the solvent reflux temperature, and reflux was performed for 10 hours for the reaction to proceed. Note that the reaction was carried out under an argon gas atmosphere.

Next, after the obtained reaction solution was cooled close to room temperature, 30 g of toluene was added to the reaction solution. This reaction solution was allowed to stand, and phase separation was performed. Thus, a toluene solution was recovered. Next, the obtained toluene solution was filtered to thereby remove insolubles. Subsequently, the toluene solution was washed with a 3% by mass aqueous solution of sodium N,N-diethyldithiocarbamate trihydrate, and allowed to stand. Then, the phase-separated toluene solution was recovered. Next, the toluene solution was washed with a 3% by mass acetic acid aqueous solution, and allowed to stand. Then, the phase-separated toluene solution was recovered. Subsequently, the toluene solution was washed with ion-exchanged water, and allowed to stand. Then, the phase-separated toluene solution was recovered. Next, the toluene solution was filtered, and then passed through an alumina column for purification. Thereafter, the toluene solution was poured into methanol for reprecipitation purification, and the formed precipitates were collected. Then, after washed with methanol, the obtained precipitates were vacuum-dried. Thus, 0.3 g of the polymer compound (5) was obtained.

The thus obtained polymer compound (5) had a polystyrene equivalent weight average molecular weight of 4.9×10³ and a polystyrene equivalent number average molecular weight of 2.3×10³. It can be estimated, from the feed, that the polymer compound (5) obtained by the production method as described above has repeating units shown in the following formulae:

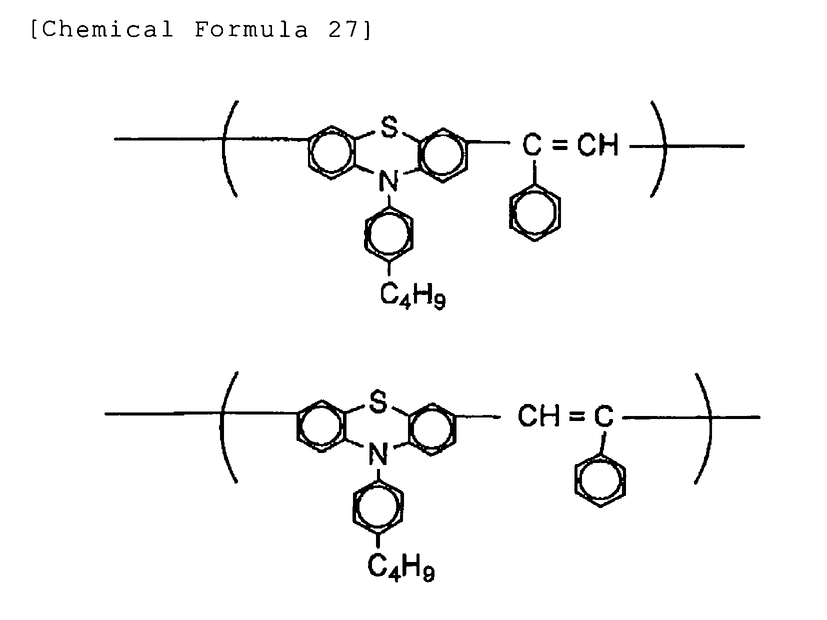

### (Comparative Example 2: Synthesis of Polymer Compound (6))

Poly[2-methoxy-5-(2'-ethylhexyloxy)-1,4-phenylen e vinylene] (manufactured by Sigma-Aldrich Corporation, number average molecular weight: 40,000 to 70,000) represented by the following structural formula (VII): 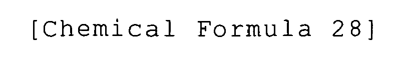 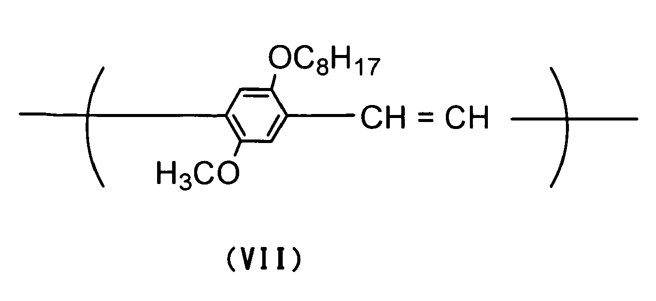 was used as the polymer compound (6).

### (Comparative Example 3: Synthesis of Polymer Compound (7))

First, 0.464 g of a monomer (9) represented by the following structural formula (VIII): 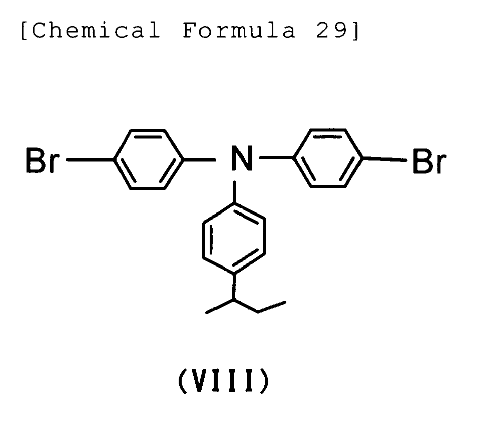 , 0.356 g of the monomer (20), 0.15 g of methyltrioctylammonium chloride (product name "aliquat 336 (registered trademark of Henkel Corp.)", manufactured by Sigma-Aldrich Corporation, CH₃N[(CH₂)₇CH₃]₃Cl, density: 0.884 g/ml (at 25°C), and 1.8 mg of dichloro bis(triphenylphosphine) palladium(II) were fed into a reaction vessel, and the air inside the reaction vessel was replaced with argon gas. Next, into the reaction vessel, 15 ml of toluene which was deaerated by argon gas bubbling beforehand was added, to thereby obtain a solution. Subsequently, to the solution, 5 ml of a 16.7% by mass sodium carbonate aqueous solution which was deaerated by argon gas bubbling beforehand was added dropwise over several minutes. Then, the temperature was raised to the solvent reflux temperature, and reflux was performed for 10 hours for the reaction to proceed. Note that the reaction was carried out under an argon gas atmosphere. Next, after the obtained reaction solution was cooled close to room temperature, 30 g of toluene was added to the reaction solution. This reaction solution was allowed to stand, and phase separation was performed. Thus, a toluene solution was recovered. Subsequently, the toluene solution was washed with a 3% by mass aqueous solution of sodium N,N-diethyldithiocarbamate trihydrate, and allowed to stand. Then, the phase-separated toluene solution was recovered. Subsequently, the toluene solution was washed with a 3% by mass acetic acid aqueous solution, and allowed to stand. Then, the phase-separated toluene solution was recovered. Next, the toluene solution was washed with ion-exchanged water, and allowed to stand. Then, the phase-separated toluene solution was recovered. Subsequently, the toluene solution was filtered, and then passed through an alumina column for purification. Thereafter, the toluene solution was poured into methanol for reprecipitation purification, and the formed precipitates were collected. Then, after washed with methanol, the obtained precipitates were vacuum-dried. Thus, 0.30 g of the polymer compound (7) was obtained.

The thus obtained polymer compound (7) had a polystyrene equivalent weight average molecular weight of 5.7×10³ and a polystyrene equivalent number average molecular weight of 2.3×10³. It can be estimated, from the feed, that the polymer compound (7) obtained by the production method as described above has repeating units shown in the following formulae:

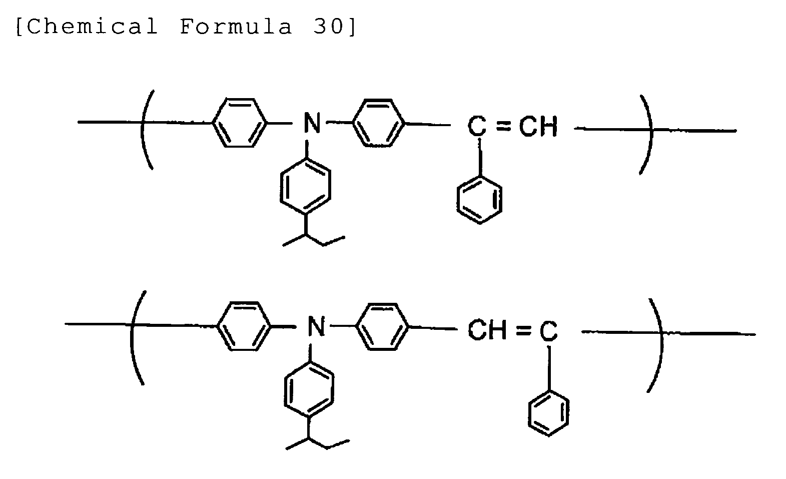

### (Examples 5 to 8 and Comparative Examples 4 to 6: Production of Thin Films)

By using each of the polymer compounds (1) to (7), a 0.8% by mass toluene solution was prepared. The toluene solution was spin-coated on a quartz glass plate. Thus, a thin film of each of the polymer compounds was formed.

### [Fluorescence Properties Evaluation on Polymer Compounds (1) to (8)]

### <Evaluation Method>

By using the thin films obtained in Examples 5 to 8 and Comparative Examples 4 to 6, the fluorescence peak wavelengths and the fluorescence intensities were measured. Specifically, first, a fluorescence spectrum of each of the thin films was measured by using a spectrofluorometer (manufactured by JOBINYVON-SPEX under the product name of "Fluorolog" ) under a condition of an excitation wavelength of 350 nm. Then, in order to obtain relative fluorescence intensity of the thin film, a fluorescence spectrum plotted against wavenumber with the intensity of the Raman spectrum of water taken as the standard was integrated within the measurement range of the spectrum. Then, a value obtained by dividing this integrated value by the absorbance measured by using a spectrophotometer (manufactured by Varian, Inc. under the product name of "Cary5E" ) at the excitation wavelength was determined as the fluorescence intensity of the corresponding thin film. Table 1 shows the determination results of the fluorescence peak wavelength and the fluorescence intensity obtained by such determination.

**[Table 1]**

| | KIND OF POLYMER COMPOUND USED FOR THIN FILM | FLUORESCENCE PEAK WAVELENGTH [UNIT: nm] | FLUORESCENCE INTENSITY [RELATIVE INTENSITY] |
|---|---|---|---|
| EXAMPLE 5 | POLYMER COMPOUND (1) | 471 | 8.2 |
| EXAMPLE 6 | POLYMER COMPOUND (2) | 485 | 10.1 |
| EXAMPLE 7 | POLYMER COMPOUND (3) | 483 | 10.8 |
| EXAMPLE 8 | POLYMER COMPOUND (4) | 469 | 9.7 |
| COMPARATIVE EXAMPLE 4 | POLYMER COMPOUND (5) | 531 | 1.0 |
| COMPARATIVE EXAMPLE 5 | POLYMER COMPOUND (6) | 588 | 0.9 |
| COMPARATIVE EXAMPLE 6 | POLYMER COMPOUND (7) | 521 | 1.2 |

As apparent from the results shown in Table 1, the thin films of the present invention (Examples 5 to 8) obtained by using the polymer compounds (1) to (4), which correspond to the polymer compound of the present invention, each exhibited a higher fluorescence intensity than the thin films (Comparative Examples 4 to 6) obtained by using the polymer compounds (5) to (7) for comparison. These results show that the polymer compound of the present invention (Examples 1 to 4) exhibits a sufficiently high fluorescence intensity.

### (Example 9: Synthesis of Polymer Compound (40))

### <Preparation of Solution (S1)>

First, the solution (S1) which was used for the synthesis of a polymer compound (40) was prepared as follows. Specifically, first, 0.995 g of the monomer (3), 0.350 g of the monomer (10), 1.6 mg of palladium(II) acetate, and 8.2 mg of tris(2-methoxyphenyl)phosphine were fed into a reaction vessel, and the air inside the reaction vessel was sufficiently replaced with argon gas. Next, into the reaction vessel, 15 ml of toluene which was deaerated by argon gas bubbling beforehand was added, to thereby obtain the solution (S1).

### <Synthesis of Polymer Compound (40)>

First, 0.477 g of a monomer (40) represented by the following structural formula (IX): 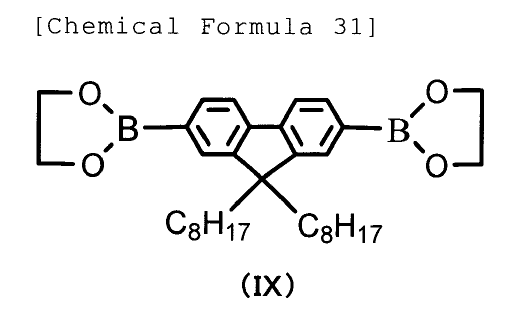 , 0.683 g of a monomer (41) represented by the structural formula (X): 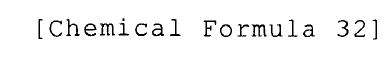 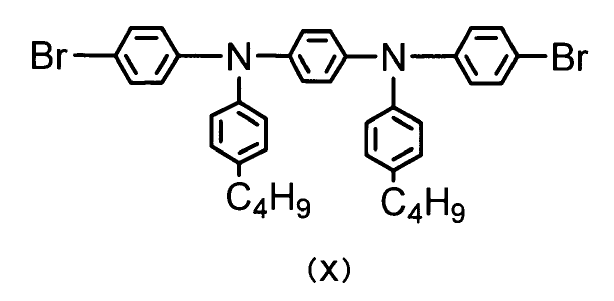 , 0.40 g of methyltrioctylammonium chloride (product name "aliquat 336 (registered trademark of Henkel Corp.)", manufactured by Sigma-Aldrich Corporation, CH₃N[(CH₂)₇CH₃]₃Cl, density: 0.884 g/ml (at 25°C), 2.0 mg of palladium(II) acetate, and 13.3 mg of tris(2-methoxyphenyl)phosphine were fed into a reaction vessel, and the air inside the reaction vessel was sufficiently replaced with argon gas. Next, into the reaction vessel, 20 ml of toluene which was deaerated by argon gas bubbling beforehand was added, to thereby obtain a solution. Subsequently, to the solution, 5 ml of a 16.7% by mass sodium carbonate aqueous solution which was deaerated by argon gas bubbling beforehand was added dropwise. Then, the temperature was raised to the solvent reflux temperature, and reflux was performed for 3 hours. Thus, a reaction solution (I) was obtained. Note that the reaction was carried out under an argon gas atmosphere.

Next, the obtained reaction solution (I) was cooled to room temperature. Then, to the reaction solution (I), the solution (S1) which was prepared beforehand in the different reaction vessel (argon gas-purged) was added. Thus, a reaction solution (II) was obtained. Subsequently, to the obtained reaction solution (II), 5 ml of a 16.7% by weight sodium carbonate aqueous solution which was deaerated by argon gas bubbling beforehand was added dropwise. Then, the temperature was raised to the solvent reflux temperature, and reflux was performed for 3.5 hours. Thus, a reaction solution (III) was obtained. Note that the reaction was carried out under an argon gas atmosphere.

Next, the obtained reaction solution (III) was cooled to room temperature. Then, to the reaction solution (III), a solution mixture containing 0.16 g of phenylboronic acid and 0.5 ml of tetrahydrofuran was added, and reflux was performed for 2 hours. Thus, a reaction solution (IV) was obtained. Note that the reaction was carried out under an argon gas atmosphere. After such reaction, the obtained reaction solution (IV) was cooled to room temperature. Thereafter, to the reaction solution (IV), approximately 30 g of toluene was added, and was allowed to stand. Then, the phase-separated toluene layer was recovered. Subsequently, the obtained toluene layer was poured into methanol for reprecipitation. Then, the formed precipitates were collected. Next, after vacuum-dried, the precipitates were dissolved in toluene again. Thus, a toluene solution was obtained. Then, the obtained toluene solution was filtered to thereby remove insolubles. Thereafter, the toluene solution was passed through an alumina column for purification. Next, the obtained toluene solution was concentrated in vacuo, and then poured into methanol for reprecipitation. Then, the formed precipitates were collected. Subsequently, after washed with methanol, the obtained precipitates were vacuum-dried. Thus, 0.93 g of a polymer product (the polymer compound (40)) was obtained.

The thus obtained polymer compound (40) had a polystyrene equivalent weight average molecular weight of 2.4×10⁴ and a polystyrene equivalent number average molecular weight of 1.3×10⁴. It can be estimated, from the feed, that the polymer compound (40) obtained by the production method as described above has repeating units shown in the following formulae:

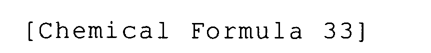

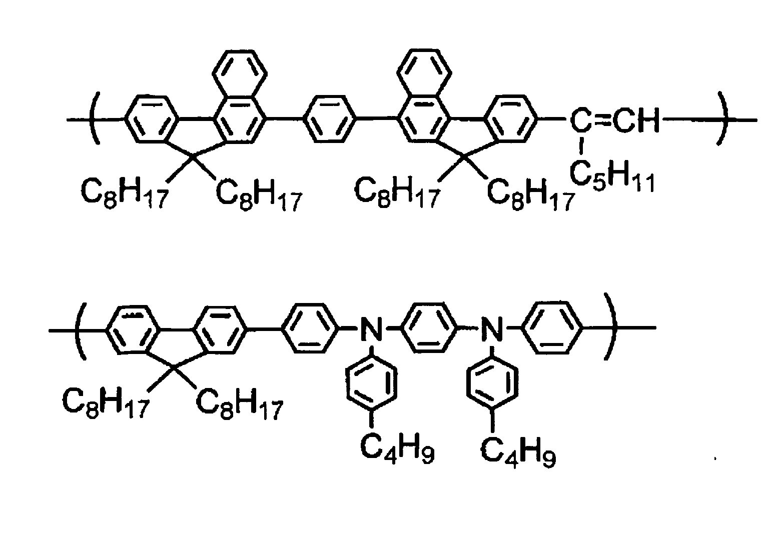

### [Production of Devices and Characteristics evaluation of the Devices]

### (Example 10)

First, the polymer compound (40) synthesized in Example 9 was dissolved in xylene to prepare a xylene solution (A) with a polymer concentration of 1.8% by weight.

Next, a liquid obtained by filtering an suspension of poly (3,4) ethylenedioxythiophene/polystyrenesulfonic acid (manufactured by Bayer AG under the product name of "BaytronP AI4083" ) by using a membrane filter with a pore diameter of 0.2 µm was spin-coated onto a glass substrate which was coated with an ITO film with a thickness of 150 nm by a sputtering method. Thus, a thin film with a thickness of 65 nm was formed on the ITO film. Then, the substrate with the film was dried on a hot plate at 200°C for 10 minutes to thereby form a first film on the ITO film. Thus, a laminated body (glass substrate/ITO film/first film) was obtained.

Subsequently, a liquid obtained by filtering the xylene solution (A) by use of a filter with a pore diameter of 0.2 µm was spin-coated onto the first film of the laminated body (at a rotational speed of 900 rpm). Thus, a thin film was formed. The film thickness of the thin film was approximately 75 nm. Thereafter, the laminated body in which the thin film was formed was allowed to stand under conditions of a nitrogen atmosphere and of 90°C for 10 minutes to thereby dry the thin film. Thus, a second film was formed on the first film. In this way, a device precursor (glass substrate/ITO film/first film/second film) was obtained.

Subsequently, the device precursor was set in a deposition apparatus, and barium was deposited as a cathode in a thickness of approximately 5 nm. Further, aluminum was deposited thereon in a thickness of approximately 80 nm. Thus, an EL device (device structure: glass substrate /ITO film/first film/second film/cathode) was produced. Note that, in these deposition processes, the deposition was started after the degree of vacuum reached 1×10⁻⁴ Pa or less.

The thus obtained EL device was subjected to voltage application. As a result, EL light emission peaked at 470 nm was obtained from the EL device. It was found that the light emission color of the EL device at a luminance of 100 cd/m² was represented by x = 0.208 and y = 0.301 in terms of C. I. E. chromaticity coordinate values.

### (Example 11)

First, the polymer compound (2) synthesized in Example 2 was dissolved in xylene to prepare a xylene solution (B) with a polymer concentration of 2.5% by weight.

Next, a liquid obtained by filtering a suspension of poly(3,4)ethylenedioxythiophene/polystyrenesulfonic acid (manufactured by Bayer AG under the product name of "BaytronP CH8000" ) by using a membrane filter with a pore diameter of 0.2 µm was spin-coated onto a glass substrate which was coated with an ITO film with a thickness of 150 nm by a sputtering method. Thus, a thin film with a thickness of 65 nm was formed. Then, the substrate with the film was dried on a hot plate at 200°C for 10 minutes. Thus, a laminated body (glass substrate/ITO film/first film) in which the first film was formed on the ITO film was obtained.

Next, a liquid obtained by filtering the xylene solution (B) by use of a filter with a pore diameter of 0.2 µm was spin-coated onto the first film of the laminated body (at a rotational speed of 2000 rpm). Thus, a thin film was formed. The film thickness of the thin film was approximately 80 nm. Thereafter, the laminated body in which the thin film was formed was allowed to stand under conditions of a nitrogen atmosphere and of 90°C for 10 minutes to thereby dry the thin film. Thus, a second film was formed on the first film. In this way, a device precursor (glass substrate /ITO film/first film/second film) was obtained.

Subsequently, the device precursor was set in a deposition apparatus, and barium was deposited as a cathode in a thickness of approximately 5 nm. Further, aluminum was deposited in a thickness of approximately 80 nm. Thus, an EL device (device structure: glass substrate/ITO film/first film/second film/cathode) was produced. Note that, in these deposition processes, the deposition was started after the degree of vacuum reached 1×10⁻⁴ Pa or less.

The thus obtained EL device was subjected to voltage application. As a result, it was found that EL light emission peaked at 485 nm was obtained from the EL device. It was found that the light emission color of the EL device at a luminance of 100 cd/m² was represented by x = 0.236 and y = 0.402 in terms of C. I. E. chromaticity coordinate values.

### (Example 12)

An EL device was produced by adopting the same method as in Example 13, except that a xylene solution (C) with a polymer concentration of 2.5% by weight obtained by dissolving the polymer compound (4) synthesized in Example 4 in xylene was used in place of the xylene solution (B).

The thus obtained EL device was subjected to voltage application. As a result, it was found that EL light emission peaked at 470 nm was obtained from the EL device. It was found that the light emission color of the EL device at a luminance of 100 cd/m² was represented by x = 0.180 and y = 0.240 in terms of C. I. E. chromaticity coordinate values.

### Industrial Applicability

As has been described above, according to the present invention, it is possible to provide: a polymer compound exhibiting a sufficiently high fluorescence intensity, and being suitably usable as a light-emitting material, a charge transport material, and the like; a method for producing the same; and a light-emitting material, a liquid composition, a thin film, a polymer light-emitting device, a surface light source, a display device, an organic transistor and a solar cell, each using the polymer compound.

Therefore, the polymer compound of the present invention is excellent in fluorescence intensity, and hence particularly useful as a light-emitting material, a charge transport material, and the like.

## Claims

1. A polymer compound comprising a repeating unit represented by the following general formula (1): 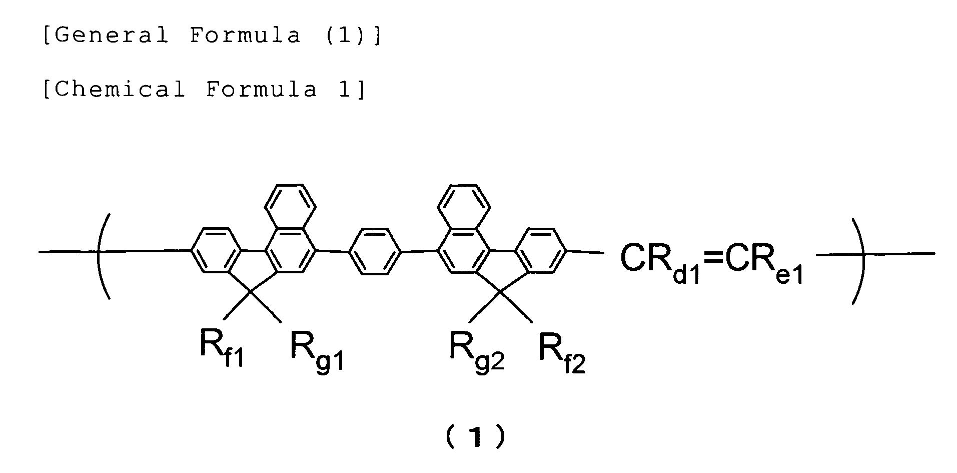 (in the formula, R_{f1}, R_{g1}, R_{f2}, and R_{g2} are the same or different, and each represents any one of an alkyl group having 1 to 12 carbon atoms, a phenyl group, a phenyl group substituted by an alkyl group having 1 to 12 carbon atoms, and a phenyl group substituted by an alkoxy group having 1 to 12 carbon atoms, and R_{d1} and Rₑ₁ are the same or different, and each represents any one of a hydrogen atom, an alkyl group having 1 to 12 carbon atoms, and a phenyl group).

2. The polymer compound according to claim 1, further comprising a repeating unit represented by the following general formula (2): 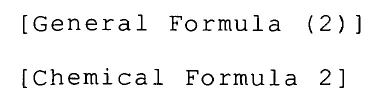 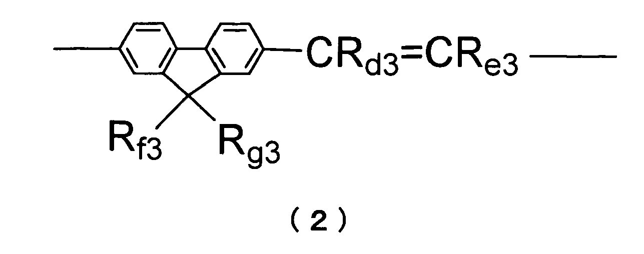 (in the formula, R_{f3} and R_{g3} are the same or different, and each represents any one of an alkyl group having 1 to 12 carbon atoms, a phenyl group, a phenyl group substituted by an alkyl group having 1 to 12 carbon atoms, and a phenyl group substituted by an alkoxy group having 1 to 12 carbon atoms, and R_{d3} and Rₑ₃ are the same or different, and each represents any one of a hydrogen atom, an alkyl group having 1 to 12 carbon atoms and a phenyl group).

3. The polymer compound according to claim 1, wherein at least one of R_{d1} and Rₑ₁ in the general formula (1) is an alkyl group having 1 to 12 carbon atoms.

4. The polymer compound according to claim 2, wherein at least one of R_{d3} and Rₑ₃ in the general formula (2) is an alkyl group having 1 to 12 carbon atoms.

5. The polymer compound according to claim 1, wherein at least one of R_{d1} and Rₑ₁ in the general formula (1) is each a phenyl group.

6. The polymer compound according to claim 2, wherein at least one of R_{d3} and Rₑ₃ in the general formula (2) is a phenyl group.

7. A method for producing a polymer compound, which is a method for producing a polymer compound according to claim 1, the method comprising reacting a compound represented by the following general formula (100) with a compound represented by the following general formula (200) in the presence of a palladium catalyst and a base to obtain the polymer compound:
[General Formula (100)] X¹-C(A¹)=C(A²)-X² (100)
(in the formula, A¹ and A² are the same or different, and each represents any one of a hydrogen atom, an alkyl group having 1 to 12 carbon atoms and a phenyl group, and X¹ and X² are the same or different, and each represents any one of a boronic acid group and a boronic ester group)
[General Formula (200)] Y¹-Ar₂₀₀-Y² (200)
{in the formula, Ar₂₀₀ represents a group represented by the following formula (201): 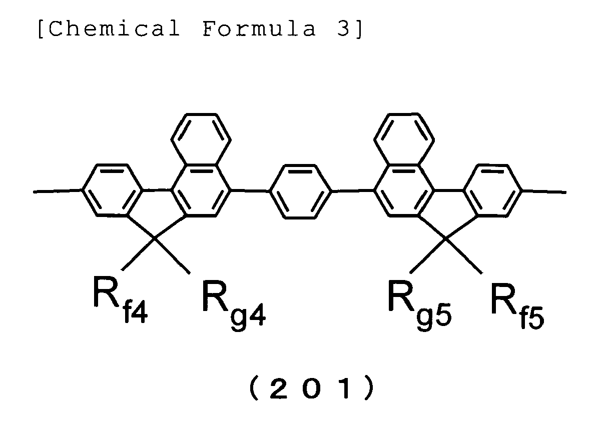 (in the formulae, R_{f4}, R_{g4}, R_{f5}, and R_{g5} are the same or different, and each represents any one of an alkyl group having 1 to 12 carbon atoms, a phenyl group, a phenyl group substituted by an alkyl group having 1 to 12 carbon atoms, and a phenyl group substituted by an alkoxy group having 1 to 12 carbon atoms), and
Y¹ and Y² are the same or different, and each represents any one of a halogen atom, an alkyl sulfonate group, an aryl sulfonate group and an aryl alkyl sulfonate group}.

8. A light-emitting material comprising the polymer compound according to claim 1.

9. A liquid composition comprising:
the polymer compound according to claim 1; and
a solvent.

10. A thin film comprising the polymer compound according to claim 1.

11. A polymer light-emitting device comprising an organic layer containing the polymer compound according to claim 1, said organic layer being located between electrodes including an anode and a cathode.

12. A surface light source comprising the polymer light-emitting device according to claim 11.

13. A display device comprising the polymer light-emitting device according to claim 11.

14. An organic transistor comprising the polymer compound according to claim 1.

15. A solar cell comprising the polymer compound according to claim 1.
